# EUROPEAN PATENT APPLICATION

(11) **EP 4 672 210 A1**
(43) Date of publication of application: **31.12.2025**
(21) Application number: 24810104.0
(22) Date of filing: 18.04.2024
(51) Int. Cl.: G09G 3/3208

(54) **DISPLAY SUBSTRATE AND MANUFACTURING METHOD THEREFOR, DISPLAY PANEL, AND DISPLAY DEVICE**

(30) Priority: 19.05.2023 CN 202310574391
(71) Applicant: Boe Technology Group Co., Ltd., Beijing 100015 (CN); Beijing BOE Technology Development Co., Ltd., Beijing 100176 (CN)
(72) Inventor: LV, Guangshuang, Beijing 100176 (CN); XU, Pan, Beijing 100176 (CN); HAN, Ying, Beijing 100176 (CN); ZHANG, Xing, Beijing 100176 (CN); LUO, Chengyuan, Beijing 100176 (CN); ZHAO, Donghui, Beijing 100176 (CN); XU, Cheng, Beijing 100176 (CN); YAO, Xing, Beijing 100176 (CN); LIU, Miao, Beijing 100176 (CN)
(74) Representative: Hoffmann Eitle
(86) International application number: PCT/CN2024/088472
(87) International publication number: WO 2024/239857

(57) **Abstract**

A display substrate has a display area and a peripheral area located on at least one side of the display area. A display panel comprises three first power lines and a light-emitting control circuit. The three first power lines are arranged in the peripheral area. Each first power line extends substantially in a first direction and is configured to transmit a first signal or a second signal. The light-emitting control circuit is arranged in the peripheral area. The light-emitting control circuit comprises a plurality of cascaded light-emitting shift registers. At least one first power line is located on the side of the light-emitting control circuit away from the display area, the other at least two first power lines overlap the light-emitting control circuit, and each light-emitting shift register is divided into a first light-emitting sub-circuit, a second light-emitting sub-circuit and a third light-emitting sub-circuit. The first light-emitting sub-circuit, the second light-emitting sub-circuit and the third light-emitting sub-circuit are sequentially close to the display area. The first light-emitting sub-circuit and the third light-emitting sub-circuit each comprise a first-type transistor connected to a first power line, and the first-type transistors are respectively connected to the nearest first power lines.

## Description

This application claims priority to Chinese Patent Application No. 202310574391.7, filed on May 19, 2023, which is incorporated herein by reference in its entirety.

### TECHNICAL FIELD

The present disclosure relates to the field of display technologies, and in particular, to a display substrate and a method for manufacturing the same, a display panel and a display apparatus.

### BACKGROUND

With the rapid development of display technologies, display apparatuses have gradually come throughout people's lives. Organic light-emitting diodes (OLEDs) are widely used in smart products such as mobile phones, televisions, and notebook computers due to their advantages of self-luminescence, low power consumption, wide viewing angle, fast response speed, high contrast, and flexible display.

### SUMMARY

In an aspect, a display substrate is provided. The display substrate includes a display region and a peripheral region located on at least one side of the display region. The display substrate includes: a plurality of first power lines and a light-emitting control circuit. The plurality of first power lines are disposed in the peripheral region. A first power line extends substantially along a first direction and is configured to transmit a first signal or a second signal.

The light-emitting control circuit is disposed in the peripheral region. The light-emitting control circuit includes a plurality of light-emitting shift registers that are cascaded. At least one first power line is located on a side of the light-emitting control circuit away from the display region, and other at least two first power lines overlap the light-emitting control circuit and divide a light-emitting shift register into a first light-emitting sub-circuit, a second light-emitting sub-circuit and a third light-emitting sub-circuit. The first light-emitting sub-circuit, the second light-emitting sub-circuit and the third light-emitting sub-circuit are proximate to the display region in sequence.

The first light-emitting sub-circuit and the third light-emitting sub-circuit each include a first type transistor connected to a first power line, and first type transistors are connected to nearest first power lines, respectively.

In some embodiments, the display substrate further includes a plurality of second power lines. A second power line extends substantially along the first direction and is configured to transmit a third signal or a fourth signal. In the plurality of second power lines, at least one second power line is disposed on the side of the light-emitting control circuit away from the display region, and another at least one second power line is disposed between the light-emitting control circuit and the display region. The first light-emitting sub-circuit and the third light-emitting sub-circuit each include a second type transistor, and the second type transistors in the first light-emitting sub-circuit and the third light-emitting sub-circuit are connected to nearest second power lines, respectively.

In some embodiments, orthogonal projections of a first power line and a second power line that are located on the side of the light-emitting control circuit away from the display region on a reference plane at least partially overlap. The reference plane is a plane where a surface of a non-display side of the display substrate is located.

In some embodiments, in a first power line and a second power line located on the side of the light-emitting control circuit away from the display region, the first power line is located on a side of the second power line away from or proximate to the display region.

In some embodiments, a width of a second power line connected to the third light-emitting sub-circuit is less than a width of a second power line connected to the first light-emitting sub-circuit.

In some embodiments, the display substrate further includes a plurality of second connecting lines extending substantially along a second direction. The second direction intersects the first direction. An end of a second connecting line is connected to a second type transistor, and another end of the second connecting line is connected to a nearest second power line.

In some embodiments, the at least two second power lines include a first type second power line and a second type second power line. The first type second power line is configured to transmit the third signal. The first type second power line is disposed on the side of the light-emitting control circuit away from the display region. The second type second power line is configured to transmit the fourth signal. The second type second power line is disposed between the light-emitting control circuit and the display region.

In some embodiments, the first light-emitting sub-circuit is coupled to a first power signal terminal, a second power signal terminal, a first signal input terminal, a first reset signal terminal, a first clock signal terminal, a second clock signal terminal, a first cascade output terminal, a first control node, and a second control node. The first light-emitting sub-circuit is configured to: under control of signals from the first signal input terminal, the first clock signal terminal, and the second clock signal terminal, output any one of the first signal, the second signal, the third signal, and the fourth signal to the first control node, the second control node, and the first cascade output terminal; and under control of a signal from the first reset signal terminal, output a first clock signal to the first control node, and output the first signal or the second signal to the second control node.

The second light-emitting sub-circuit is coupled to the first control node and an enable signal output terminal. The second light-emitting sub-circuit is configured to raise a voltage of the first control node in a case where the enable signal output terminal outputs the first signal or the second signal.

The third light-emitting sub-circuit is coupled to the first power signal terminal, the second power signal terminal, the first control node, the second control node and the enable signal output terminal. The third light-emitting sub-circuit is configured to output any one of the first signal, the second signal, the third signal and the fourth signal to the enable signal output terminal under control of voltages of the first control node and the second control node, and raise a voltage of the second control node in a case where the enable signal output terminal outputs the third signal or the fourth signal.

In some embodiments, a width of a first power line connected to the third light-emitting sub-circuit is greater than a width of a first power line connected to the first light-emitting sub-circuit.

In some embodiments, the display substrate further includes a plurality of first connecting lines extending substantially along a second direction. The second direction intersects the first direction. An end of a first connecting line is connected to a first type transistor, and another end of the first connecting line is connected to a nearest first power line.

In some embodiments, the display substrate further includes a first start signal line, a first clock signal line, a second clock signal line and a first reset signal line. The first start signal line is connected to the light-emitting control circuit, and the first start signal line is located on the side of the light-emitting control circuit away from the display region. The first clock signal line is connected to the light-emitting control circuit, and the first clock signal line is located on the side of the light-emitting control circuit away from the display region. The second clock signal line is connected to the light-emitting control circuit, and the second clock signal line is located on the side of the light-emitting control circuit away from the display region. The first reset signal line is connected to the light-emitting control circuit, and the first reset signal line is located between two first power lines overlapping with the light-emitting control circuit.

In some embodiments, the display substrate further includes a plurality of third power lines and a scanning driving circuit. The plurality of third power lines are disposed in the peripheral region. A third power line extends substantially along the first direction, and is configured to transmit a fifth signal or a sixth signal.

The scanning driving circuit is disposed in the peripheral region. The scanning driving circuit includes a plurality of scanning shift registers that are cascaded. At least three third power lines overlap the scanning driving circuit, and divide the scanning shift register into a first scanning sub-circuit, a second scanning sub-circuit, a third scanning sub-circuit and a fourth scanning sub-circuit. The first scanning sub-circuit, the second scanning sub-circuit, the third scanning sub-circuit and the fourth scanning sub-circuit are proximate to the display region in sequence.

The first scanning sub-circuit, the second scanning sub-circuit and the third scanning sub-circuit each include a third type transistor connected to a third power line; third type transistors in the first scanning sub-circuit, the second scanning sub-circuit and the third scanning sub-circuit are connected to nearest third power lines, respectively.

In some embodiments, the display substrate further includes a plurality of fourth power lines. A fourth power line extends substantially along the first direction and is configured to transmit a seventh signal or an eighth signal. In the plurality of fourth power lines, at least one fourth power line is disposed between the second scanning sub-circuit and the third scanning sub-circuit, and another at least one fourth power line is disposed between the fourth scanning sub-circuit and the display region. The second scanning sub-circuit and the fourth scanning sub-circuit each include a fourth type transistor, and fourth type transistors in the second scanning sub-circuit and the fourth scanning sub-circuit are connected to nearest fourth power lines, respectively.

In some embodiments, orthogonal projections of a third power line and a fourth power line that are located between the second scanning sub-circuit and the third scanning sub-circuit on a reference plane at least partially overlap. The reference plane is a plane where a display surface of the display substrate is located.

In some embodiments, in a third power line and a fourth power line that are located between the second scanning sub-circuit and the third scanning sub-circuit, the third power line is located on a side of the fourth power line away from or proximate to the display region.

In some embodiments, a width of a third power line connected to the third scanning sub-circuit is less than a width of a third power line connected to the first scanning sub-circuit and/or the second scanning sub-circuit.

In some embodiments, the display substrate includes a plurality of fourth connecting lines. The plurality of fourth connecting lines extend substantially along a second direction. The second direction intersects the first direction. An end of the fourth connecting line is connected to a fourth type transistor, and another end of the fourth connecting line is connected to a nearest fourth power line.

In some embodiments, the first scanning sub-circuit is coupled to a third power signal terminal, a second signal input terminal, a third signal input terminal, a first voltage terminal, a second voltage terminal, a second reset signal terminal, a second cascade output terminal, a third control node and a fourth control node.

The first scanning sub-circuit is configured to: output a first voltage signal or a second voltage signal to the third control node under control of voltages of the second signal input terminal and the third signal input terminal; output the fifth signal or the sixth signal to the fourth control node; and output the fifth signal or the sixth signal to the third control node under control of a signal from the second reset signal terminal.

The second scanning sub-circuit is coupled to the third power signal terminal, a fourth power signal terminal, the third control node, the fourth control node and the second cascade output terminal. The second scanning sub-circuit is configured to output the fifth signal or the sixth signal to the second cascade output terminal under control of a voltage of the fourth control node, and output the fifth signal or the sixth signal to the fourth control node under control of a signal from the second cascade output terminal or the fourth power signal terminal.

The third scanning sub-circuit is coupled to the third power signal terminal, a third clock signal terminal, the third control node, the fourth control node, the second cascade output terminal and a scanning signal output terminal. The third scanning sub-circuit is configured to output a third clock signal to the second cascade output terminal under control of voltages of the third control node and the fourth control node, and output any one of the third clock signal, the fifth signal and the sixth signal to the scanning signal output terminal.

The fourth scanning sub-circuit is coupled to a fourth clock signal terminal, the fourth power signal terminal, the fourth control node and the scanning signal output terminal. The fourth scanning sub-circuit is configured to output the seventh signal or the eighth signal to the scanning signal output terminal under control of the signal from the fourth power signal terminal, and output a fourth clock signal to the fourth control node under control of a signal from the fourth clock signal terminal.

In some embodiments, the display substrate includes a plurality of third connecting lines extend substantially along a second direction. The second direction intersects the first direction. An end of a third connecting line is connected to a third type transistor, and another end of the third connecting line is connected to a nearest third power line.

In some embodiments, the plurality of third power lines include: two first type third power lines and a second type third power line. The two first type third power lines are configured to transmit the fifth signal. A first type third power line is disposed between the first scanning sub-circuit and the second scanning sub-circuit, and another first type third power line is disposed between the second scanning sub-circuit and the third scanning sub-circuit. The second type third power line is configured to transmit the sixth signal. The second type third power line is disposed between the third scanning sub-circuit and the fourth scanning sub-circuit.

In some embodiments, the display substrate further includes a second start signal line, a third start signal line, a first voltage signal line, a second voltage signal line, a third clock signal line, a fourth clock signal line, and a second reset signal line.

The second start signal line is connected to the scanning driving circuit, and the second start signal line is located on a side of the scanning driving circuit away from the display region. The third start signal line is connected to the scanning driving circuit, and the third start signal line is located on a side of the scanning driving circuit along the first direction. The first voltage signal line is connected to the scanning driving circuit, and the first voltage signal line is located on the side of the scanning driving circuit away from the display region. The second voltage signal line is connected to the scanning driving circuit, and the second voltage signal line is located on the side of the scanning driving circuit away from the display region.

The third clock signal line is connected to the scanning driving circuit, and the third clock signal line is located between the scanning driving circuit and the display region. The fourth clock signal line is connected to the scanning driving circuit, and the fourth clock signal line is located between the scanning driving circuit and the display region. The second reset signal line is connected to the scanning driving circuit, and the second reset signal line is located between the first scanning sub-circuit and the second scanning sub-circuit.

In another aspect, a display panel is provided. The display panel includes the display substrate in any one of the above embodiments.

In yet another aspect, a display apparatus is provided. The display apparatus includes the display panel in any one of the above embodiments.

In yet another aspect, a method for manufacturing a display substrate is provided. The method for manufacturing the display substrate used for manufacturing the display substrate in any one of the above embodiments. The display substrate includes a first power line, a second power line, a third power line, a fourth power line, a first start signal line, a second start signal line, a third start signal line, a first voltage signal line, a second voltage signal line, a first clock signal line, a second clock signal line, a third clock signal line, a first reset signal line and a second reset signal line.

The method for manufacturing the display substrate includes: forming a semiconductor layer, a gate insulating layer, a gate conductive layer, an interlayer insulating layer, a first source-drain conductive layer and a first planarization layer on a substrate in sequence. The first source-drain conductive layer includes at least one of the first power line, the second power line, the third power line, the fourth power line, the first start signal line, the second start signal line, the third start signal line, the first voltage signal line, the second voltage signal line, the first clock signal line, the second clock signal line, the third clock signal line, the first reset signal line and the second reset signal line.

In some embodiments, orthogonal projections of the first power line, the second power line, the third power line, the fourth power line, the first start signal line, the second start signal line, the third start signal line, the first voltage signal line, the second voltage signal line, the first clock signal line, the second clock signal line, the third clock signal line, the first reset signal line and the second reset signal line on a reference plane are staggered; the reference plane is a plane where a surface of a non-display side of the display substrate is located.

The first source-drain conductive layer includes the first power line, the second power line, the third power line, the fourth power line, the first start signal line, the second start signal line, the third start signal line, the first voltage signal line, the second voltage signal line, the first clock signal line, the second clock signal line, the third clock signal line, the first reset signal line and the second reset signal line.

In some embodiments, orthogonal projections of the first power line and the second power line located on a side of the light-emitting control circuit away from the display region on a reference plane at least partially overlap; and/or orthogonal projections of the third power line and the fourth power line located between the second scanning sub-circuit and the third scanning sub-circuit on the reference plane at least partially overlap; the reference plane is a plane where a surface of a non-display side of the display substrate is located.

The method for manufacturing the display substrate further includes: forming a second source-drain conductive layer on a side of the first planarization layer away from the substrate; and forming a second planarization layer on a side of the second source-drain conductive layer away from the substrate.

In a case where the orthogonal projections of the first power line and the second power line located on the side of the light-emitting control circuit away from the display region on the reference plane at least partially overlap, the first source-drain conductive layer includes the first power line, the third power line, the fourth power line, the first start signal line, the second start signal line, the third start signal line, the first voltage signal line, the second voltage signal line, the first clock signal line, the second clock signal line, the third clock signal line, the first reset signal line and the second reset signal line; the second source-drain conductive layer includes the second power line.

In a case where the orthogonal projections of the third power line and the fourth power line located between the second scanning sub-circuit and the third scanning sub-circuit on the reference plane at least partially overlap, the first source-drain conductive layer includes the first power line, the second power line, the third power line, the first start signal line, the second start signal line, the third start signal line, the first voltage signal line, the second voltage signal line, the first clock signal line, the second clock signal line, the third clock signal line, the first reset signal line and the second reset signal line; the second source-drain conductive layer includes the fourth power line.

In a case where the orthogonal projections of the first power line and the second power line located on the side of the light-emitting control circuit away from the display region on the reference plane at least partially overlap, and the orthogonal projections of the third power line and the fourth power line located between the second scanning sub-circuit and the third scanning sub-circuit on the reference plane at least partially overlap, the first source-drain conductive layer includes the first power line, the third power line, the first start signal line, the second start signal line, the third start signal line, the first voltage signal line, the second voltage signal line, the first clock signal line, the second clock signal line, the third clock signal line, the first reset signal line and the second reset signal line; the second source-drain conductive layer includes the second power line and the fourth power line.

### BRIEF DESCRIPTION OF THE DRAWINGS

In order to describe technical solutions in some embodiments of the present disclosure more clearly, the accompanying drawings to be used in some embodiments of the present disclosure will be introduced briefly; obviously, the accompanying drawings to be described below are merely some embodiments of the present disclosure, and a person of ordinary skill in the art can obtain other drawings according to those drawings. In addition, the accompanying drawings in the following description may be regarded as schematic diagrams, but are not limitations on actual sizes of products, actual processes of methods and actual timings of signals involved in the embodiments of the present disclosure.
FIG. 1 is a structural diagram of a display apparatus, in accordance with some embodiments;
FIG. 2 is a structural diagram of another display apparatus, in accordance with some embodiments;
FIG. 3 is a sectional view taken along the section line A-A' in FIG. 1;
FIG. 4 is a structural diagram of a display panel, in accordance with some embodiments;
FIG. 5 is a sectional view taken along the section line B-B' in FIG. 4;
FIG. 6 is another sectional view taken along the section line B-B' in FIG. 4;
FIG. 7 is a structural diagram of a gate driving circuit of a display panel, in accordance with some embodiments;
FIG. 8 is a structural diagram of a light-emitting control circuit of a display panel and signal lines connected to the light-emitting control circuit, in accordance with some embodiments;
FIG. 9 is a structural diagram of a light-emitting control circuit of another display panel and signal lines connected to the light-emitting control circuit, in accordance with some embodiments;
FIG. 10 is a structural layout of the light-emitting control circuit of the display panel and the signal lines connected to the light-emitting control circuit shown in FIG. 8;
FIG. 11 is a structural diagram of a first light-emitting sub-circuit of a display panel, in accordance with some embodiments;
FIG. 12 is a structural diagram of a second light-emitting sub-circuit of a display panel, in accordance with some embodiments;
FIG. 13 is a structural diagram of a third light-emitting sub-circuit of a display panel, in accordance with some embodiments;
FIG. 14 is a circuit diagram of a light-emitting shift register of a display panel, in accordance with some embodiments;
FIG. 15 is a structural diagram of a scanning driving circuit of a display panel and signal lines connected to the scanning driving circuit, in accordance with some embodiments;
FIG. 16 is a structural diagram of a scanning driving circuit of another display panel and signal lines connected to the scanning driving circuit, in accordance with some embodiments;
FIG. 17 is a structural diagram of a first scanning sub-circuit of a display panel, in accordance with some embodiments;
FIG. 18 is a structural diagram of a second scanning sub-circuit of a display panel, in accordance with some embodiments;
FIG. 19 is a structural diagram of a third scanning sub-circuit of a display panel, in accordance with some embodiments;
FIG. 20 is a structural diagram of a fourth scanning sub-circuit of a display panel, in accordance with some embodiments; and
FIG. 21 is a circuit diagram of a scanning shift register of a display panel, in accordance with some embodiments.

### DETAILED DESCRIPTION

The technical solutions in some embodiments of the present disclosure will be described clearly and completely with reference to the accompanying drawings; obviously, the described embodiments are merely some but not all embodiments of the present disclosure. All other embodiments obtained by a person having ordinary skill in the art based on the embodiments of the present disclosure shall be included in the protection scope of the present disclosure.

Unless the context requires otherwise, throughout the description and claims, the term "comprise" and other forms thereof such as the third-person singular form "comprises" and the present participle form "comprising" are construed as an open and inclusive meaning, i.e., "including, but not limited to". In the description of the specification, terms such as "one embodiment", "some embodiments", "exemplary embodiments", "example", "specific example" or "some examples" are intended to indicate that specific features, structures, materials or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics described may be included in any one or more embodiments or examples in any suitable manner.

The terms "first" and "second" are used for descriptive purposes only, and are not to be construed as indicating or implying a relative importance or implicitly indicating a number of indicated technical features. Thus, a feature defined with "first" or "second" may explicitly or implicitly include one or more of the features. In the description of the embodiments of the present disclosure, the term "a plurality of" / "the plurality of" means two or more unless otherwise specified.

Some embodiments may be described using the terms "coupled", "connected" and their derivatives. For example, the term "connected" may represent a fixed connection, or a detachable connection, or a one-piece connection; alternatively, the term "connected" may represent a direct connection, or an indirect connection through an intermediate medium. For example, the term "coupled" indicates that two or more components are in direct physical or electrical contact. The term "coupled" or "communicatively coupled" may also mean that two or more components are not in direct contact with each other but still cooperate or interact with each other. The embodiments disclosed herein are not necessarily limited to the content herein.

The phrase "at least one of A, B, and C" has the same meaning as the phrase "at least one of A, B, or C", both including the following combinations of A, B, and C: only A, only B, only C, a combination of A and B, a combination of A and C, a combination of B and C, and a combination of A, B, and C.

The phrase "A and/or B" includes following three combinations: only A, only B, and a combination of A and B.

As used herein, the term "if" is, optionally, construed as "when" or "in a case where" or "in response to determining that" or "in response to detecting", depending on the context. Similarly, depending on the context, the phrase "if it is determined that" or "if [a stated condition or event] is detected" is optionally construed as "in a case where it is determined that" or "in response to determining that" or "in a case where [the stated condition or event] is detected" or "in response to detecting [the stated condition or event]".

The use of the phrase "applicable to" or "configured to" herein means an open and inclusive expression, which does not exclude devices that are applicable to or configured to perform additional tasks or steps.

In addition, the use of the phrase "based on" or "according to" is meant to be open and inclusive, since a process, step, calculation or other action that is "based on" or "according to" one or more of the stated conditions or values may, in practice, be based on or according to additional conditions or values exceeding those stated.

As used herein, "about", "approximately", or "substantially" are inclusive of the stated value and mean within an acceptable range of deviation for the particular value as determined by a person of ordinary skill in the art, taking into account the measurements in question and the errors associated with measurement of a particular quantity (i.e., limitations of the measurement system). For example, "about" may mean within one or more standard deviations, or within ± 30%, ± 20%, ± 10%, ± 5% of the stated value.

The term such as "parallel", "perpendicular" or "equal" as used herein includes a stated case and a case similar to the stated case within an acceptable range of deviation determined by a person of ordinary skill in the art, considering measurement in question and errors associated with measurement of a particular quantity (i.e., limitations of a measurement system). For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°; and the term "equal" includes absolute equality and approximate equality, and an acceptable range of deviation of the approximate equality may be, for example, a difference between two equals being less than or equal to 5% of either of the two equals.

It will be understood that, in a case where a layer or an element is referred to as being on another layer or a substrate, it may be that the layer or the element is directly on the another layer or the substrate, or there may be a middle layer between the layer or the element and the another layer or the substrate.

Exemplary embodiments are described herein with reference to sectional views and/or plan views that are schematic illustrations of idealized embodiments. In the drawings, thicknesses of layers and sizes of regions are enlarged for clarity. Variations in shape with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a feature being curved. Therefore, the regions shown in the accompanying drawings are schematic in nature, and their shapes are not intended to show actual shapes of the regions in a device, and are not intended to limit the scope of the exemplary embodiments.

In this specification, unless otherwise defined, all terms used herein (including technical terms and scientific terms) have the same meaning as is commonly understood by those skilled in the art to which the present disclosure belongs. It will be further understood that unless expressly defined herein, terms (e.g., those defined in commonly used dictionaries) should be interpreted as having a meaning that is consistent with their meaning in the context of the relevant art, and should not be interpreted as an ideal or overly formal meaning.

In the present disclosure, terms such as "lower", "below", "above", and "upper", and the like are used to explain the relational association of components shown in the drawings. The terms may be relative concepts and described based on the directions shown in the drawings, or based on the order in which the process steps are formed, but are not limited thereto.

The term "opposed to" means that a first element may be directly or indirectly opposed to a second element. In a case where a third element is interposed between the first element and the second element, the first element and the second element may be understood as being indirectly opposite to each other although still opposite to each other.

In a shift register provided in embodiments of the present disclosure, transistors used in the shift register may be thin film transistors (TFTs), metal oxide semiconductor (MOS) transistors, or other switching devices with same properties, and the embodiments of the present disclosure are described by taking the thin film transistors as an example.

In the shift register provided in the embodiments of the present disclosure, a control electrode of each TFT used in the shift register is a gate of the TFT, a first electrode of the TFT is one of a source and a drain of the TFT, and a second electrode of the TFT is another one of the source and the drain of the TFT. Since the source and the drain of the transistor may be symmetrical in structure, there may be no difference in structure between the source and the drain thereof. That is, there may be no difference in structure between the first electrode and the second electrode of the TFT in the embodiments of the present disclosure. For example, for a P-type transistor, the first electrode of the transistor is the source, and the second electrode thereof is the drain. For example, for the N-type transistor, the first electrode of the transistor is the drain, and the second electrode of the transistor is the source.

In the embodiments of the present disclosure, a capacitor may be a capacitive device individually fabricated by a process, for example, by fabricating specialized capacitive electrodes to realize the capacitive device, and the individual capacitive electrodes of the capacitor may be realized by a metal layer, a semiconductor layer (e.g., doped polycrystalline silicon), or the like. The capacitor may also be a parasitic capacitor formed by transistors, or by a transistor itself and another device or line, or by lines of a circuit itself.

In the shift register provided in the embodiments of the present disclosure, nodes such as a first node, a second node, first control node and a second control node do not represent actual components, but represent junction points of related electrical connections in circuit diagrams. That is, these nodes are nodes that are equivalently formed from the junctions of related electrical connections in circuit diagrams.

A "low-level" in the shift register provided in the embodiments of the present disclosure refers to a voltage that may cause an operated P-type transistor included in the shift register to be turned on, and may not cause an operated N-type transistor included in the shift register to be turned on (i.e., the N-type transistor being turned off); correspondingly, a "high-level" refers to a voltage that may cause the operated N-type transistor included in the shift register to be turned on, and may not cause the operated P-type transistor included in the shift register to be turned on (i.e., the P-type transistor being turned off).

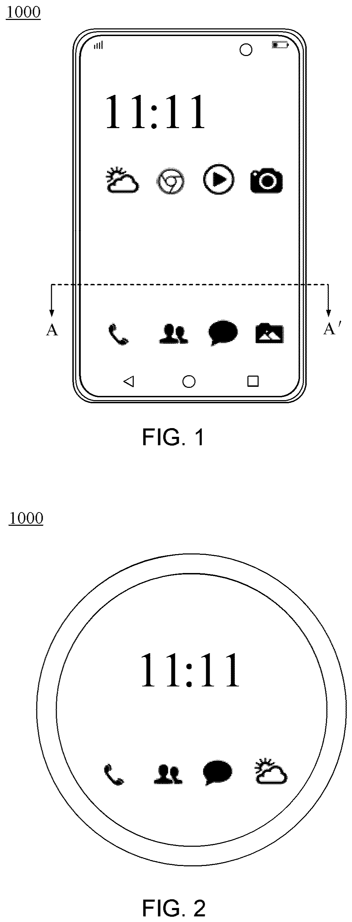

Referring to FIGS. 1 and 2, some embodiments of the present disclosure provide a display apparatus 1000, and the display apparatus 1000 may be any apparatus that displays an image whether in motion (e.g., a video) or stationary (e.g., a still image), and whether textual or graphical.

For example, the display apparatus 1000 may be any product or component having a display function, such as a television, a notebook computer, a tablet computer, a mobile phone, a personal digital assistant (PDA), a navigator, a wearable device, a virtual reality (VR) device.

As shown in FIG. 1, the display apparatus 1000 may be, for example, a vehicle-mounted display. For example, the display apparatus 1000 may be the mobile phone as shown in FIG. 1. For another example, referring to FIG. 2, the display apparatus 1000 may be a wearable device. For example, the display apparatus 1000 may be the watch shown in FIG. 2.

Some embodiments of the present disclosure will be illustrated below by taking an example in which the above display apparatus 1000 is the mobile phone shown in FIG. 1, but embodiments of the present disclosure are not limited thereto.

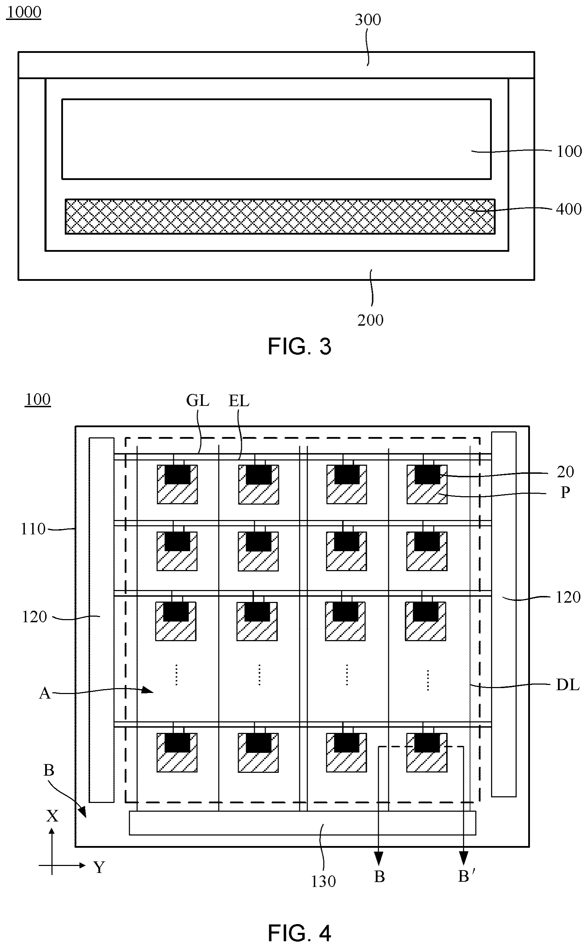

In some embodiments, referring to FIG. 3, the display apparatus 1000 includes a display panel 100.

The display panel includes a light-exit side and a non-light-exit side arranged opposite thereto; the light-exit side is a side of the display panel 100 used for display, which is an upper side in FIG. 3.

For example, as shown in FIG. 3, the display apparatus 1000 may further include a housing 200, a cover plate 300, a circuit board 400 and other electronic components.

Referring to FIG. 3, the cover plate 300 may be a single-layer glass cover plate, or may include multiple layers of cover sub-plates that are stacked, which is not limited in the embodiments of the present disclosure.

As shown in FIG. 3, a longitudinal section of the housing 200 is, for example, U-shaped. The display panel 100 and the circuit board 400 are disposed in the housing 200. The cover plate 300 is disposed on an opening of the housing 200. The circuit board 400 is disposed on a side of the display panel 100 away from the cover plate 300, and the circuit board 400 is connected to the display panel 100 to provide the display panel 100 with a required display signal.

Type of the display panel 100 varies, which may be selected according to actual needs.

For example, the display panel 100 may be an organic light emitting diode (OLED) display panel, or a quantum dot light emitting diode (QLED) display panel, which is not limited in the present disclosure.

Some embodiments of the present disclosure will be schematically described below by taking an example in which the display panel 100 is the OLED display panel.

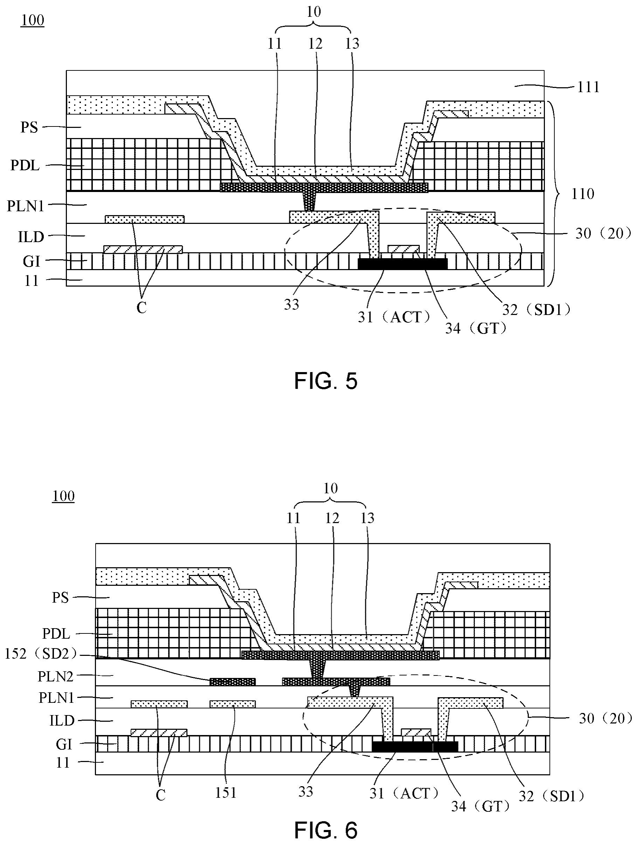

In some embodiments, referring to FIGS. 4 and 5, the display panel 100 includes a display substrate 110 and an encapsulation layer 111 for encapsulating the display substrate 110.

The display substrate 110 has a display side and a non-display side that are arranged opposite to each other. The encapsulation layer 111 is arranged on the display side of the display substrate 110 to prevent moisture and oxygen in the external environment from entering the display panel 100, which may cause a service life of the display panel 100 to be shortened.

The encapsulation layer 111 may be an encapsulation film or an encapsulation substrate.

In some embodiments, referring to FIG. 4, the display substrate 110 has a display region A and a peripheral region B disposed on at least one side of the display region A.

FIG. 4 illustrates an example in which the peripheral region B is arranged around the display region A.

Here, the display region A is a region for displaying images, and is configured to be provided therein with a plurality of sub-pixels P.

For example, referring to FIG. 4, the display substrate 110 includes a substrate 11 and the plurality of sub-pixels P disposed on a side of the substrate 11 and located in the display region A.

The substrate 11 may be varies, which is determined according to actual needs.

For example, the substrate 11 may be a rigid substrate. The rigid substrate may be, for example, a glass substrate or a polymethyl methacrylate (PMMA) substrate.

As another example, the substrate 11 may be a flexible substrate. For example, the flexible substrate may be a polyethylene terephthalate (PET) substrate, a polyethylene naphthalate two formic acid glycol ester (PEN) substrate, or a polyimide (PI) substrate.

Referring to FIGS. 4, 5, and 6, each sub-pixel P includes a light-emitting device 10 and a pixel circuit 20. The pixel circuit 20 includes a plurality of thin film transistors 30.

As shown in FIGS. 5 and 6, the thin film transistor 30 includes a semiconductor channel 31, a source 32, a drain 33 and a gate 34. The source 32 and the drain 33 are respectively in contact with the semiconductor channel 31.

As shown in FIGS. 5 and 6, the light-emitting device 10 includes a first electrode 11, a light-emitting functional layer 12, and a second electrode 13. The first electrode 11 is electrically connected to a source 32 or a drain 33 of a thin film transistor 30. FIGS. 5 and 6 illustrate an example in which the first electrode 11 is electrically connected to the drain 33 of the thin film transistor 30.

It will be noted that the light-emitting functional layer 12 may include only a light-emitting layer; or in addition to the light-emitting layer, the light-emitting functional layer 22 further includes at least one of an electron transporting layer (ETL), an electron injection layer (EIL), a hole transporting layer (HTL) and a hole injection layer (HIL).

In some embodiments, as shown in FIGS. 5 and 6, the display substrate 110 further includes a pixel defining layer PDL. The pixel defining layer PDL is provided with a plurality of openings therein, and a light-emitting device 10 is located in an opening.

In some embodiments, as shown in FIGS. 5 and 6, the display substrate 110 further includes a spacer PS. The spacer PS may be disposed between the pixel defining layer PDL and the first electrode 11 of the light-emitting device 10, so as to support the mask during the process, so that a gap between the mask and the pixel defining layer PDL is uniform.

In some embodiments, as shown in FIG. 4, all sub-pixels P are arranged in multiple rows and multiple columns. Each column of sub-pixels P includes multiple sub-pixels P arranged along a first direction X, and each row of sub-pixels P includes multiple sub-pixels P arranged along a second direction Y. The first direction X intersects the second direction Y. For example, the first direction X may be substantially perpendicular to the second direction Y.

It will be noted that the first direction X may be, for example, a column direction in which the multiple sub-pixels P are arranged, and the second direction Y may be, for example, a row direction in which the multiple sub-pixels P are arranged.

Hereinafter, some embodiments of the present disclosure will be illustrated by taking an example in which the all sub-pixels P are arranged in multiple rows and multiple columns, but the embodiments of the present disclosure are not limited thereto. In addition, the multiple sub-pixels P arranged along the first direction X are referred to as a column of sub-pixels P, and the multiple sub-pixels P arranged along the second direction Y are referred to as a row of sub-pixels P.

On this basis, the display substrate 110 further includes a plurality of data lines DL, a plurality of scanning signal lines GL and a plurality of light-emitting control signal lines EL.

As shown in FIG. 4, the data lines DL extend substantially along the first direction X and are configured to transmit data signals. For example, a data line DL may be connected to a column of sub-pixels P.

As shown in FIG. 4, the scanning signal lines GL extend substantially along the second direction Y and are configured to transmit scanning signals. For example, a scanning signal line GL may be connected to a row of sub-pixels P.

As shown in FIG. 4, the light-emitting control signal lines EL extend substantially along the second direction Y and are configured to transmit enable signals. For example, a light-emitting control signal line EL may be connected to a row of sub-pixels P.

In addition, the peripheral region B is a region where no image is displayed therein, and is configured to be provided therein with display driving circuits, for example, gate driving circuit(s) 120 and source driving circuit(s) 130.

As shown in FIG. 4, along the second direction Y, the gate driving circuit 120 is disposed on at least one side of the display region A and connected to the scanning signal lines GL and the light-emitting control signal lines EL, so as to respectively provide scanning signals and enable signals to the scanning signal lines GL and the light-emitting control signal lines EL.

In some examples, as shown in FIG. 4, along the second direction Y, gate driving circuits 120 are disposed on opposite sides of the display region A, and the two gate driving circuits 120 simultaneously drive the scanning signal lines GL and the light-emitting control signal lines EL row by row from opposite sides of the display region A (which is double-side driving).

In some other examples, along the second direction Y, gate driving circuits 120 are disposed on opposite sides of the display region A, and are connected to different scanning signal lines GL corresponding to different rows of sub-pixels P and different light-emitting control signal lines EL corresponding to different rows of sub-pixels P, so that the two gate driving circuits 120 alternately drives the scanning signal lines GL from both sides row by row and alternately drives the light-emitting control signal lines EL from both sides row by row (which is alternate driving).

In yet some other examples, along the second direction Y, a gate driving circuit 120 is disposed on a side of the display region A, and drives the scanning signal lines GL and the light-emitting control signal lines EL row by row from one side of the display region A (which is single-side driving).

Some embodiments of the present disclosure will be illustrated below by taking an example of the double-side driving, but the embodiments of the present disclosure are not limited thereto. In addition, the single-side driving or the alternate driving may further be considered as long as the same technical concept is applied.

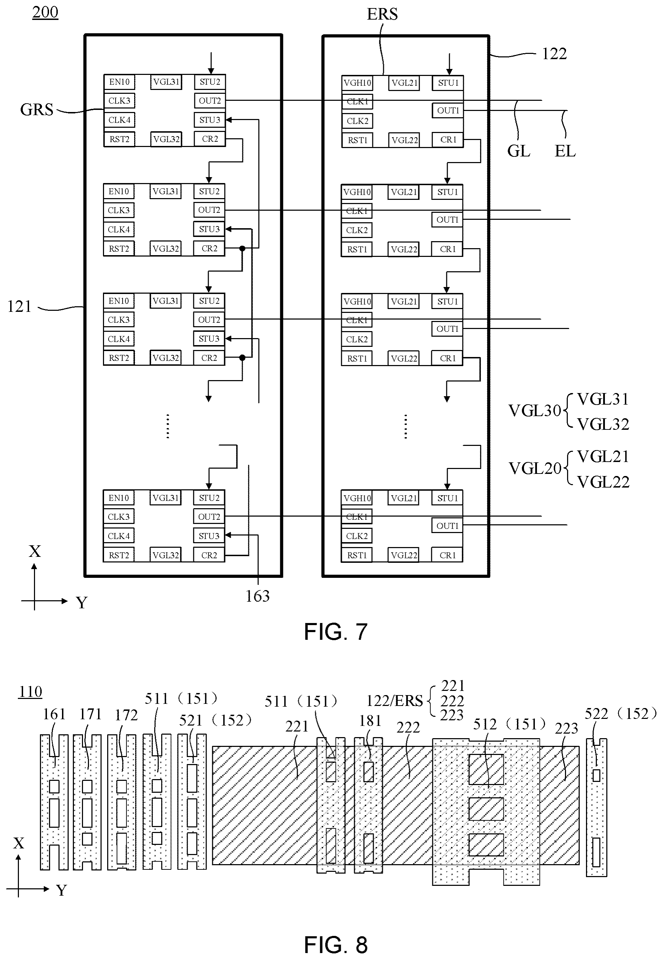

In some embodiments, referring to FIG. 7, the above-mentioned gate driving circuit 120 includes a scanning driving circuit 121 and a light-emitting control circuit 122.

In some examples, as shown in FIG. 7, the light-emitting control circuit 122 is connected to the light-emitting control signal lines EL to provide the enable signals for the light-emitting control signal lines EL.

For example, as shown in FIG. 7, the light-emitting control circuit 122 includes a plurality of light-emitting shift registers ERS that are cascaded, and each light-emitting shift register ERS is connected to at least one enable signal line EL.

In some examples, as shown in FIG. 7, the scanning driving circuit 121 is connected to the scanning signal lines GL to provide the scanning signals for the scanning signal lines GL.

For example, as shown in FIG. 7, the scanning driving circuit 121 includes a plurality of scanning shift registers GRS that are cascaded, and each scanning shift register GRS is connected to at least one scanning signal line GL.

However, as the pixel resolution of the display apparatus becomes higher and higher, a wiring space of each of the shift registers (including the scanning shift registers and the light-emitting shift registers) in a longitudinal direction (i.e., the first direction X) becomes smaller and smaller. Therefore, how to reduce the wiring space of each of the shift registers in the longitudinal direction (e.g., the first direction X) is an issue that needs to be solved urgently.

Based on this, referring to FIGS. 7 and 8, the display substrate 110 provided by some embodiments of the present disclosure further includes a plurality of first power lines 151 disposed in the peripheral region B.

As shown in FIG. 8, the first power lines 151 extend substantially along the first direction X and are configured to transmit a first signal or a second signal. Furthermore, at least one first power line 151 is located on a side of the light-emitting control circuit 122 away from the display region A, and other at least two first power lines 151 overlap with the light-emitting control circuit 122 and divide the light-emitting shift register ERS into a first light-emitting sub-circuit 221, a second light-emitting sub-circuit 222 and a third light-emitting sub-circuit 223. The first light-emitting sub-circuit 221, the second light-emitting sub-circuit 222 and the third light-emitting sub-circuit 223 are proximate to the display region A (see FIG. 4) in sequence.

It will be noted that the first signal and the second signal are both constant low-level signals or constant high-level signals. Hereinafter, some embodiments of the present disclosure will be illustrated by taking an example in which the first signal and the second signal are constant high-level signals, but the embodiments of the present disclosure are not limited thereto.

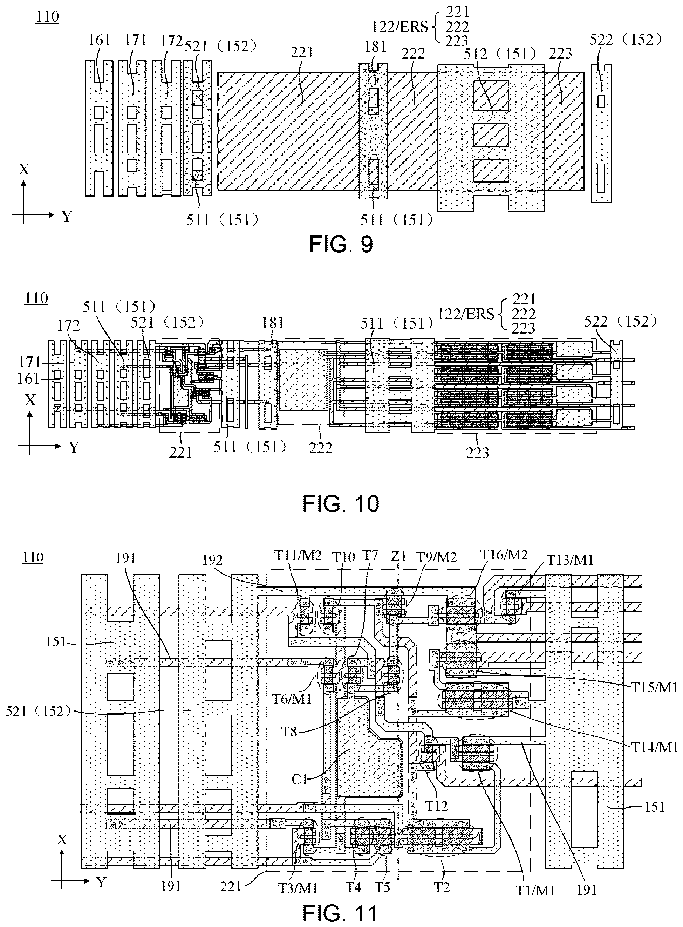

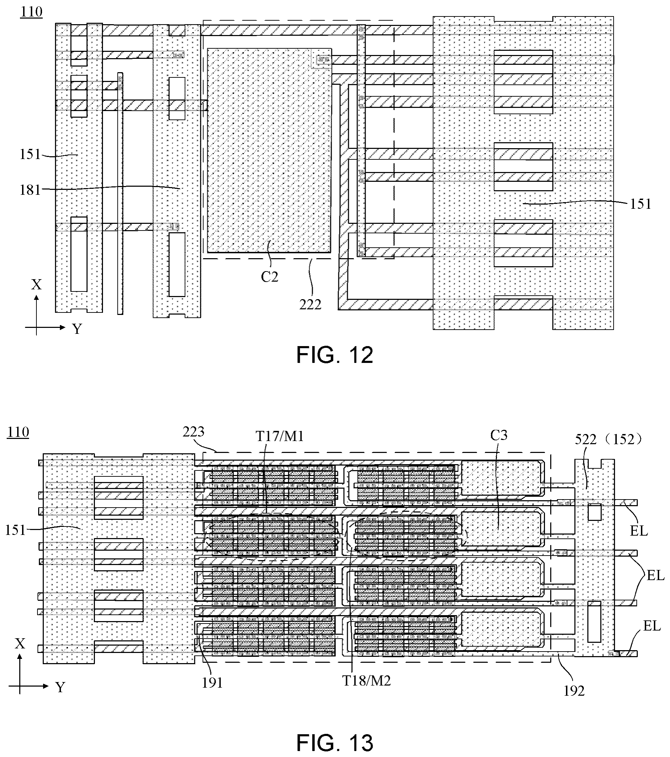

On this basis, as shown in FIGS. 11 and 13, the first light-emitting sub-circuit 221 and the third light-emitting sub-circuit 223 each include a first type transistor M1 connected to a first power line 151. The first type transistors M1 are connected to nearest first power lines 151, respectively.

Hereinafter, some embodiments of the present disclosure will be illustrated by taking an example in which the display substrate 110 includes three first power lines 151, but the embodiments of the present disclosure are not limited thereto.

In some embodiments, as shown in FIG. 7, each light-emitting shift register ERS includes a first signal input terminal STU1, a first power signal terminal VGH10, a second power signal terminal VGL20, a first clock signal terminal CLK1, a second clock signal terminal CLK2, a first reset signal terminal RST1, a first cascade output terminal CR1 and an enable signal output terminal OUT1.

On this basis, as shown in FIG. 8, the display substrate 110 includes the first power lines 151, the second power lines 152, a first start signal line 161, a first clock signal line 171, a second clock signal line 172 and a first reset signal line 181.

Furthermore, the first power lines 151, the second power lines 152, the first start signal line 161, the first clock signal line 171, the second clock signal line 172 and the first reset signal line 181 extend substantially along the first direction X and are connected to the light-emitting shift registers ERS.

Here, the first power lines 151, the second power lines 152, the first start signal line 161, the first clock signal line 171, the second clock signal line 172 and the first reset signal line 181 are provided with first hollow regions therein. Connecting lines (e.g., a first connecting line 191 and a second connecting line 192 mentioned below) intersecting with the first power lines 151, the second power lines 152, the first start signal line 161, the first clock signal line 171, the second clock signal line 172 and the first reset signal line 181 pass through first hollow regions, so as to reduce an overlapping area and reduce the risk of parasitic capacitance and accidental short circuit.

As shown in FIG. 7, a first signal input terminal STU1 of a light-emitting shift register ERS at a first stage is connected to the first start signal line 161. In light-emitting shift registers ERS at every two adjacent stages, a first signal input terminal STU1 of a light-emitting shift register ERS at a next stage is connected to a first cascade output terminal CR1 of a light-emitting shift register ERS at a previous stage. Furthermore, the enable signal output terminal OUT1 of the light-emitting shift register ERS is connected to the enable signal line EL.

A plurality of first power signal terminals VGH10 may transmit the same high-level signal, such as the first signal or the second signal. The plurality of first power signal terminals VGH10 may also be configured such that, according to actual conditions, a part of the first power signal terminals VGH10 transmits the first signal, and another part of the first power signal terminals VGH10 transmits the second signal.

That is, the plurality of first power signal terminals VGH10 may include a first type first power signal terminal VGH11 and a second type first power signal terminal VGH12. The first type first power signal terminal VGH11 transmits the first signal, and the second type first power signal terminal VGH12 transmits the second signal.

In this case, referring to FIG. 8, the plurality of first power lines 151 include first type first power line(s) 511 and second type first power line(s) 512. The first type first power line 511 is configured to transmit the first signal. The second type first power line 512 is configured to transmit the second signal.

Hereinafter, some embodiments of the present disclosure will be illustrated by taking an example in which the plurality of first power signal terminals VGH10 include the first type first power signal terminal VGH11 and the second type first power signal terminal VGH12, but the embodiments of the present disclosure are not limited thereto.

In addition, a plurality of second power signal terminals VGL20 may transmit the same low-level signal, such as a third signal or a fourth signal. The plurality of second power signal terminals VGL20 may also be configured such that, according to actual conditions, a part of the second power signal terminals VGL20 transmits the third signal, and another part of the second power signal terminals VGL20 transmit the fourth signal.

That is, the plurality of second power signal terminals VGL20 include a first type second power signal terminal VGL21 and a second type second power signal terminal VGL22. The first type second power signal terminal VGL21 transmits the third signal, and the second type second power signal terminal VGL22 transmits the fourth signal.

It will be noted that the third signal and the fourth signal are both constant low-level signals or constant high-level signals, and the levels of the third signal and the fourth signal are opposite to those of the first signal and the second signal. For example, in a case where the first signal and the second signal are both constant high-level signals, the third signal and the fourth signal are constant low-level signals.

In this case, referring to FIG. 8, the second power lines 152 include first type second power line(s) 521 and second type second power line(s) 522. The first type second power line 521 is configured to transmit the third signal. The second type second power line 522 is configured to transmit the fourth signal.

Hereinafter, some embodiments of the present disclosure will be illustrated by taking an example in which the plurality of second power signal terminals VGL20 include the first type second power signal terminal VGL21 and the second type second power signal terminal VGL22, but the embodiments of the present disclosure are not limited thereto.

In some examples, referring to FIG. 11, the first light-emitting sub-circuit 221 has a first center line Z1 extending along the first direction X, and includes a plurality of first type transistors M1. The plurality of first type transistors M1 in the first light-emitting sub-circuit 221 are located on both sides of the first center line Z1 and are respectively connected to nearest first power lines 151.

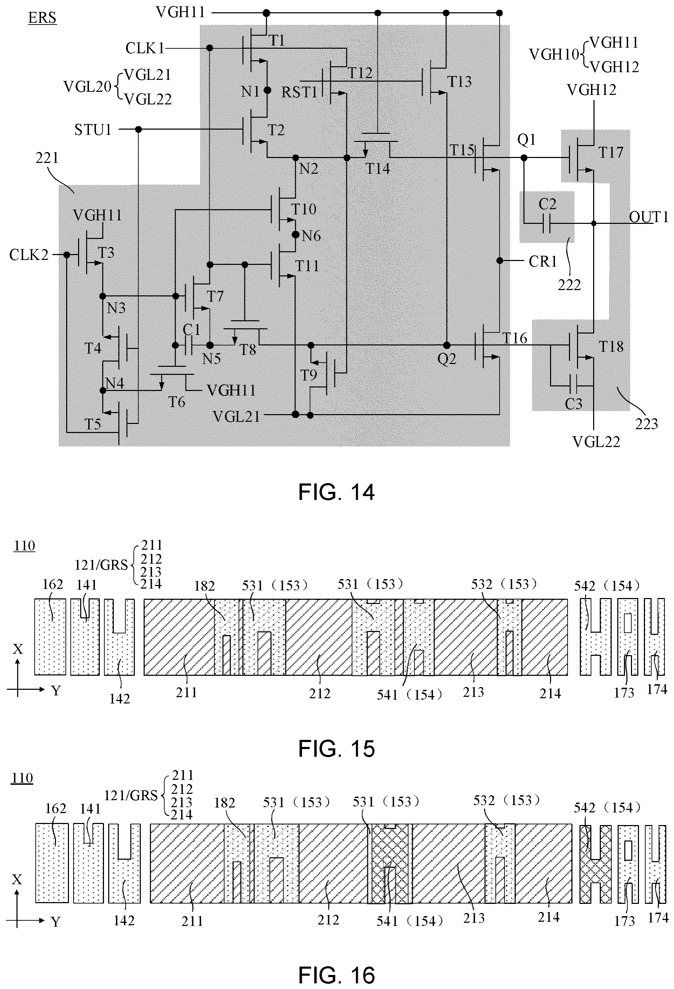

On this basis, referring to FIGS. 11 and 14, the first light-emitting sub-circuit 221 is coupled to the first power signal terminal VGH10, the second power signal terminal VGL20, the first signal input terminal STU1, the first reset signal terminal RST1, the first clock signal terminal CLK1, the second clock signal terminal CLK2, the first cascade output terminal CR1, a first control node Q1 and a second control node Q2.

In this case, the first light-emitting sub-circuit 221 is configured to: output any one of the first signal, the second signal, the third signal and the fourth signal to the first control node Q1, the second control node Q2 and the first cascade output terminal CR1 under control of signals from the first signal input terminal STI1, the first clock signal terminal CLK1 and the second clock signal terminal CLK2; and under control of a signal from the first reset signal terminal RST1, output a first clock signal to the first control node Q1, and output the first signal or the second signal to the second control node Q2.

For example, as shown in FIG. 14, the first light-emitting sub-circuit 221 is connected to the first type first power signal terminal VGH11 and the first type second power signal terminal VGL21.

For example, as shown in FIG. 14, the first light-emitting sub-circuit 221 includes a first transistor T1, a second transistor T2, a third transistor T3, a fourth transistor T4, a fifth transistor T5, a sixth transistor T6, a seventh transistor T7, an eighth transistor T8, a ninth transistor T9, a tenth transistor T10, an eleventh transistor T11, a twelfth transistor T12, a thirteenth transistor T13, a fourteenth transistor T14, a fifteenth transistor T15, a sixteenth transistor T16, and a first capacitor C1.

As shown in FIG. 14, a first electrode of the first transistor T1 is connected to the first type first power signal terminal VGH11, a second electrode of the first transistor T1 is connected to the first node N1, and a control electrode of the first transistor T1 is connected to the first clock signal terminal CLK1.

As shown in FIG. 14, a first electrode of the second transistor T2 is connected to the first node N1, a second electrode of the second transistor T2 is connected to the second node N2, and a control electrode of the second transistor T2 is connected to the first signal input terminal STU1.

As shown in FIG. 14, a first electrode of the third transistor T3 is connected to the first type first power signal terminal VGH11, a second electrode of the third transistor T3 is connected to the third node N3, and a control electrode of the third transistor T3 is connected to the second clock signal terminal CLK2.

As shown in FIG. 14, a first electrode of the fourth transistor T4 is connected to the third node N3, a second electrode of the fourth transistor T4 is connected to the fourth node N4, and a control electrode of the fourth transistor T4 is connected to the first signal input terminal STU1.

As shown in FIG. 14, a first electrode of the fifth transistor T5 is connected to the fourth node N4, a second electrode of the fifth transistor T5 is connected to the second clock signal terminal CLK2, and a control electrode of the fifth transistor T5 is connected to the first signal input terminal STU1.

As shown in FIG. 14, a first electrode of the sixth transistor T6 is connected to the first type first power signal terminal VGH11, a second electrode of the sixth transistor T6 is connected to the fourth node N4, and a control electrode of the sixth transistor T6 is connected to the third node N3.

As shown in FIG. 14, a first electrode of the seventh transistor T7 is connected to the first clock signal terminal CLK1, a second electrode of the seventh transistor T7 is connected to the fifth node N5, and a control electrode of the seventh transistor T7 is connected to the third node N3.

As shown in FIG. 14, a first electrode of the eighth transistor T8 is connected to the fifth node N5, a second electrode of the eighth transistor T8 is connected to the second control node Q2, and a control electrode of the eighth transistor T8 is connected to the first clock signal terminal CLK1.

As shown in FIG. 14, a first electrode of the ninth transistor T9 is connected to the first type second power signal terminal VGL21, a second electrode of the ninth transistor T9 is connected to the second control node Q2, and a control electrode of the ninth transistor T9 is connected to the second node N2.

As shown in FIG. 14, a first electrode of the tenth transistor T10 is connected to the second node N2, a second electrode of the tenth transistor T10 is connected to the sixth node N6, and a control electrode of the tenth transistor T10 is connected to the third node N3.

As shown in FIG. 14, a first electrode of the eleventh transistor T11 is connected to the sixth node N6, a second electrode of the eleventh transistor T11 is connected to the first type second power signal terminal VGL21, and a control electrode of the eleventh transistor T11 is connected to the first clock signal terminal CLK1.

As shown in FIG. 14, a first electrode of the twelfth transistor T12 is connected to the first clock signal terminal CLK1, a second electrode of the twelfth transistor T12 is connected to the second node N2, and a control electrode of the twelfth transistor T12 is connected to the first reset signal terminal RST1.

As shown in FIG. 14, a first electrode of the thirteenth transistor T13 is connected to the first type first power signal terminal VGH11, a second electrode of the thirteenth transistor T13 is connected to the second control node Q2, and a control electrode of the thirteenth transistor T13 is connected to the first reset signal terminal RST1.

As shown in FIG. 14, a first electrode of the fourteenth transistor T14 is connected to the second node N2, a second electrode of the fourteenth transistor T14 is connected to the first control node Q1, and a control electrode of the fourteenth transistor T14 is connected to the first type first power signal terminal VGH11.

As shown in FIG. 14, a first electrode of the fifteenth transistor T15 is connected to the first type first power signal terminal VGH11, a second electrode of the fifteenth transistor T15 is connected to the first cascade output terminal CR1, and a control electrode of the fifteenth transistor T15 is connected to the first control node Q1.

As shown in FIG. 14, a first electrode of the sixteenth transistor T16 is connected to the first type second power signal terminal VGL21, a second electrode of the sixteenth transistor T16 is connected to the first cascade output terminal CR1, and a control electrode of the sixteenth transistor T16 is connected to the second control node Q2.

As shown in FIG. 14, a first electrode plate of the first capacitor C1 is connected to the third node N3, and a second electrode plate of the first capacitor C1 is connected to the fifth node N5.

In some examples, referring to FIGS. 12 and 14, the second light-emitting sub-circuit 222 is coupled to the first control node Q1 and the enable signal output terminal OUT1.

The second light-emitting sub-circuit 222 is configured to raise a voltage of the first control node Q1 in a case where the enable signal output terminal OUT1 outputs the first signal or the second signal.

For example, as shown in FIG. 14, the second light-emitting sub-circuit 222 is connected to the first type first power signal terminal VGH11.

For example, as shown in FIG. 14, the second light-emitting sub-circuit 222 includes a second capacitor C2. A first electrode plate of the second capacitor C2 is connected to the first control node Q1, and a second electrode plate of the second capacitor C2 is connected to the enable signal output terminal OUT1.

In some examples, referring to FIGS. 13 and 14, the third light-emitting sub-circuit 223 is coupled to the first type first power signal terminal VGH11, the second power signal terminal VGL, the first control node Q1, the second control node Q2, and the enable signal output terminal OUT1.

The third light-emitting sub-circuit 223 is configured to output any one of the first signal, the second signal, the third signal and the fourth signal to the enable signal output terminal OUT1 under control the voltages of the first control node Q1 and the second control node Q2, and raise the voltage of the second control node Q2 in a case where the enable signal output terminal OUT1 outputs the third signal or the fourth signal.

For example, as shown in FIG. 14, the third light-emitting sub-circuit 223 is connected to the second type first power signal terminal VGH12 and the second type second power signal terminal VGL22. The second type first power line 512 and the second type second power line 522 may be disposed separately to avoid interference from other circuits, so that the second signal or the fourth signal output by the enable signal output terminal OUT1 is more stable.

For example, as shown in FIG. 14, the third light-emitting sub-circuit 223 includes a seventeenth transistor T17, an eighteenth transistor T18, and a third capacitor C3.

As shown in FIG. 14, a first electrode of the seventeenth transistor T17 is connected to the second type first power signal terminal VGH12, a second electrode of the seventeenth transistor T17 is connected to the enable signal output terminal OUT1, and a control electrode of the seventeenth transistor T17 is connected to the first control node Q1.

As shown in FIG. 14, a first electrode of the eighteenth transistor T18 is connected to the second type second power signal terminal VGL22, a second electrode of the eighteenth transistor T18 is connected to the enable signal output terminal OUT1, and a control electrode of the eighteenth transistor T18 is connected to the second control node Q2.

It will be noted that the seventeenth transistor T17 and the eighteenth transistor T18 may be plural in number, and the number of seventeenth transistors T17 and the number of eighteenth transistors T18 may be set according to the number of the enable signal lines EL connected to the third light-emitting sub-circuit 223. FIG. 13 illustrates an example in which four seventeenth transistors T17 are connected in parallel, and four eighteenth transistors T18 are connected in parallel.

Based on the above-mentioned first light-emitting sub-circuit 221, as shown in FIGS. 11 and 14, the plurality of first type transistors M1 in the first light-emitting sub-circuit 221 include the first transistor T1, the third transistor T3, the sixth transistor T6, the thirteenth transistor T13, the fourteenth transistor T14, and the fifteenth transistor T15.

Referring to FIGS. 11 and 14, the third transistor T3 and the sixth transistor T6 are located on a side (a left side in FIG. 11) of the first center line Z1 away from the display region A (see FIG. 4), and the first transistor T1, the thirteenth transistor T13, the fourteenth transistor T14 and the fifteenth transistor T15 are located on a side (a right side in FIG. 11) of the first center line Z1 proximate to the display region A (see FIG. 4).

That is, as shown in FIGS. 8, 10 and 11, the third transistor T3 and the sixth transistor T6 are connected to a first power line 151 (a first power line 151 on the left side of FIG. 11) located on the side of the light-emitting control circuit 122 away from the display region A, and the first transistor T1, the thirteenth transistor T13, the fourteenth transistor T14 and the fifteenth transistor T15 are connected to a first power line 151 (a first power line 151 on the right side of FIG. 11) located between the first light-emitting sub-circuit 221 and the second light-emitting sub-circuit 222.

In this case, in the first light-emitting sub-circuit 221, the plurality of first type transistors M1 each may be directly connected to the nearest first power line 151 to avoid bypassing the wires in the second direction Y, thereby reducing the wiring space of each light-emitting shift register ERS in the first direction X.

For example, as shown in FIG. 11, the display substrate 110 further includes a plurality of first connecting lines 191, and the first connecting lines 191 extend substantially along the second direction Y. An end of the first connecting line 191 is connected to the first type transistor M1, and another end of the first connecting line 191 is connected to a nearest first power line 151.

That is, in the first light-emitting sub-circuit 221, the third transistor T3 and the sixth transistor T6 may be directly connected to the first power line 151 (the first power line 151 on the left side of FIG. 11) located on the side of the light-emitting control circuit 122 away from the display region A through first connecting lines 191, respectively. The first transistor T1, the thirteenth transistor T13, the fourteenth transistor T14 and the fifteenth transistor T15 may be directly connected to the first power line 151 located between the first light-emitting sub-circuit 221 and the second light-emitting sub-circuit 222 through first connecting lines 191, respectively.

That is, each first type transistor M1 in the first light-emitting sub-circuit 221 is connected to a corresponding first power line 151, and there is no need to bypass the wires in the second direction Y, thereby reducing the wiring space of each light-emitting shift register ERS in the first direction X.

Based on the third light-emitting sub-circuit 223, as shown in FIGS. 13 and 14, the first type transistor(s) M1 in the third light-emitting sub-circuit 223 include the seventeenth transistor T17.

As shown in FIGS. 12, 13 and 14, the seventeenth transistor T17 is connected to the first power line 151 located between the second light-emitting sub-circuit 222 and the third light-emitting sub-circuit 223.

In this case, the first type transistor M1 in the third light-emitting sub-circuit 223 may be directly connected to the nearest first power line 151 to avoid bypassing the wires in the second direction Y, thereby further reducing the wiring space of each light-emitting shift register ERS in the first direction X.

For example, as shown in FIG. 13, in the third light-emitting sub-circuit 223, the seventeenth transistor T17 is directly connected to the first power line 151 (the first power line 151 on the left side in FIG. 13) located between the second light-emitting sub-circuit 222 and the third light-emitting sub-circuit 223 through a first connecting line 191. That is, the first type transistor M1 in the third light-emitting sub-circuit 223 is connected to the corresponding first power line 151, and there is no need to bypass the wires in the second direction Y, thereby further reducing the wiring space of each light-emitting shift register ERS in the first direction X.

In some embodiments, referring to FIGS. 11, 13 and 14, the first light-emitting sub-circuit 221 and the third light-emitting sub-circuit 223 each include a second type transistor M2 connected to a second power line 152.

On this basis, as shown in FIG. 8, the display substrate 110 may include a plurality of second power lines 152, and the second power lines 152 are configured to transmit the third signal or the fourth signal.

As shown in FIGS. 4 and 8, among the plurality of second power lines 152, at least one second power line 152 is disposed on a side of the light-emitting control circuit 122 away from the display region A, and another at least one second power line 152 is disposed between the light-emitting control circuit 122 and the display region A.

Hereinafter, some embodiments of the present disclosure will be illustrated by taking an example in which the display substrate 110 includes two second power lines 152, and the two second power lines 152 are respectively a first type second power line 521 and a second type second power line 522, but the embodiments of the present disclosure are not limited thereto.

It will be noted that, in a case where the two second power lines 152 include the first type second power line 521 and the second type second power line 522, the first type second power line 521 is disposed on a side of the light-emitting control circuit 122 away from the display region A, and the second type second power line 522 is disposed between the light-emitting control circuit 122 and the display region A.

In this case, the second type transistors M2 in the first light-emitting sub-circuit 221 and the third light-emitting sub-circuit 223 may be connected to nearest second power lines 152, respectively.

Based on the first light-emitting sub-circuit 221 and the third light-emitting sub-circuit 223, as shown in FIGS. 11, 13 and 14, the second type transistors M2 in the first light-emitting sub-circuit 221 include the ninth transistor T9, the eleventh transistor T11 and the sixteenth transistor T16. The second type transistor(s) M2 in the third light-emitting sub-circuit 223 include the eighteenth transistor T18.

That is, as shown in FIGS. 4 and 11, the ninth transistor T9, the eleventh transistor T11 and the sixteenth transistor T16 are connected to a second power line 152 (the first type second power line 521 in FIG. 11) located on a side of the light-emitting control circuit 122 away from the display region A. As shown in FIGS. 4 and 13, the eighteenth transistor T18 is connected to a second power line 152 (the second type second power line 522 in FIG. 13) located between the light-emitting control circuit 122 and the display region A.

In this case, the second type transistors M2 in the first light-emitting sub-circuit 221 and the third light-emitting sub-circuit 223 each may be directly connected to the nearest second power line 152, so as to avoid bypassing the wires in the second direction Y, thereby further reducing the wiring space of each light-emitting shift register ERS in the first direction X.

For example, as shown in FIG. 11, the display substrate 110 further includes a plurality of second connecting lines 192. The second connecting lines 192 extend substantially along the second direction Y. An end of the second connecting line 192 is connected to the second type transistor M2, and another end of the second connecting line 192 is connected to the nearest second power line 152.

As shown in FIG. 11, in the first light-emitting sub-circuit 221, the ninth transistor T9, the eleventh transistor T11 and the sixteenth transistor T16 may be directly connected to the first type second power line 521 through a same second connecting line 192. The eighteenth transistor T18 may be directly connected to the second type second power line 522 through a second connecting line 192.

That is, the second type transistors M2 in the first light-emitting sub-circuit 221 and the third light-emitting sub-circuit 223 are connected to the corresponding second power lines 152, and there is no need to bypass the wires in the second direction Y, thereby further reducing the wiring space of each light-emitting shift register ERS in the first direction X.

In some embodiments, referring to FIGS. 8, 11 and 13, a width of the second power line 152 connected to the third light-emitting sub-circuit 223 is less than a width of the second power line 152 connected to the first light-emitting sub-circuit 221. That is, a width of the second type second power line 522 is less than a width of the first type second power line 521.

In this case, since the width of the second type second power line 522 is less than the width of the first type second power line 521, the resistance of the second type second power line 522 is relatively large, and the voltage drop is also relatively large. In this case, in a case where the enable signal output terminal OUT1 outputs a first high-level, the second control node Q2 is at a low-level, and a gate-source voltage (Vgs) of the eighteenth transistor T18 is less than 0, which may ensure that the eighteenth transistor T18 is turned off and reduce the risk of leakage.

In some embodiments, referring to FIGS. 8, 11 and 13, the width of the first power line 151 connected to the third light-emitting sub-circuit 223 is greater than the width of the first power line 151 connected to the first light-emitting sub-circuit 221. In this case, the voltage drop of the first power line 151 connected to the third light-emitting sub-circuit 223 is relatively small, so that the first signal outputted by the enable signal output terminal OUT1 is stable.

In some embodiments, referring to FIGS. 4 and 8, the first start signal line 161 is located on a side of the light-emitting control circuit 122 away from the display region A. The first clock signal line 171 is located on the side of the light-emitting control circuit 122 away from the display region A. The second clock signal line 172 is located on the side of the light-emitting control circuit 122 away from the display region A. The first reset signal line 181 is located between two first power lines 151 overlapping the light-emitting control circuit 122.

In this case, the first transistor T1, the second transistor T2, the third transistor T3, the fourth transistor T4, the fifth transistor T5, the seventh transistor T7, the eighth transistor T8, the eleventh transistor T11, the twelfth transistor T12, the twelfth transistor T12 and the thirteenth transistor T13 may be respectively connected to the corresponding signal lines on both sides of the first light-emitting sub-circuit 221, so as to reduce the winding in the second direction Y, thereby reducing the wiring space of each light-emitting shift register ERS in the first direction X.

Here, referring to FIGS. 8 and 11, the second transistor T2, the fourth transistor T4, and the fifth transistor T5 may be connected to the first start signal line 161. The first transistor T1, the seventh transistor T7, the eighth transistor T8, the eleventh transistor T11, and the twelfth transistor T12 may be connected to the first clock signal line 171. The third transistor T3 and the fifth transistor T5 may be connected to the second clock signal line 172.

Here, referring to FIG. 8, positional relationships of the first power lines 151, the second power lines 152, the first start signal line 161, the first clock signal line 171, the second clock signal line 172 and the first reset signal line 181 is not unique, and these lines may be staggered or partially overlapped.

For example, referring to FIGS. 4 and 8, the first start signal line 161, the first clock signal line 171 and the second clock signal line 172 are staggered and arranged in sequence on the side of the light-emitting control circuit 122 away from the display region A, along the second direction Y, and along a direction from the peripheral region B to the display region A.

Furthermore, the first power lines 151 and the second power lines 152 are located on a side of the second clock signal line 172 proximate to the display region A, so that the distances between the first power lines 151 and the connected transistors as well as the distances between the second power lines 152 and the connected transistors are shortened, thereby reducing the voltage drop.

On this basis, in some examples, as shown in FIGS. 4 and 8, the first power line 151 and the second power line 152 located on the side of the light-emitting control circuit 122 away from the display region A may also be staggered. Furthermore, the first power line 151 may be located on a side of the second power line 152 away from or proximate to the display region A. FIG. 8 illustrates an example in which the first power line 151 is located on the side of the second power line 152 away from the display region A.

In addition, as shown in FIGS. 4 and 8, the first power line 151 located between the first light-emitting sub-circuit 221 and the second light-emitting sub-circuit 222 may be staggered with the first reset signal line 181. For example, the first power line 151 is located on a side of the first reset signal line 181 away from the display region A.

In this case, the first start signal line 161, the first clock signal line 171, the second clock signal line 172, the first power line 151, the second power line 152 and the first reset signal line 181 may be disposed in a same layer and made of a same material.

In some other examples, as shown in FIGS. 4 and 9, orthogonal projections of the first power line 151 and the second power line 152 located on the side of the light-emitting control circuit 122 away from the display region A on a reference plane at least partially overlap, so as to reduce the distance between the first power line 151 and the corresponding connected transistors and the distance between the second power line 152 and the corresponding connected transistors, reduce the voltage drop, and reduce the wiring space of each signal line in the second direction Y, thereby facilitating the narrow bezel design of the display panel 100. The reference plane is a plane where a surface of the non-display side of the display substrate 110 is located.

It can be understood that in a case where the first power line 151 and the second power line 152 are located in different film layers, compared to the embodiments where the orthogonal projections of the first power line 151 and the second power line 152 on the reference plane do not overlap, in the embodiments where the orthogonal projections of the first power line 151 and the second power line 152 on the reference plane at least partially overlap, a distance between a film layer where the first power line 151 is located and a film layer where the second power line 152 is located is large, so as to reduce the parasitic capacitance.

For example, in a case where the first power line 151 and the second power line 152 are located in different film layers, compared to the embodiments where the orthogonal projections of the first power line 151 and the second power line 152 on the reference plane do not overlap, in the embodiments where the orthogonal projections of the first power line 151 and the second power line 152 on the reference plane at least partially overlap, an insulating film layer, such as a planarization layer, may be added.

In addition, as shown in FIGS. 4 and 9, an orthogonal projection, on the reference plane, of the first power line 151 located between the first light-emitting sub-circuit 221 and the second light-emitting sub-circuit 222 may at least partially overlap with an orthogonal projection of the first reset signal line 181 on the reference plane, so as to reduce the distance between the first power line 151 and the corresponding connected transistors as well as the distance between the first reset signal line 181 and the corresponding connected transistors, reduce the voltage drop, and reduce the wiring space of each signal line in the second direction Y, thereby facilitating the narrow bezel design of the display panel 100.

It can be understood that in a case where the first power line 151 and the first reset signal line 181 are located in different film layers, compared to the embodiments where the orthogonal projections of the first power line 151 and the first reset signal line 181 on the reference plane do not overlap, in the embodiments where the orthogonal projections of the first power line 151 and the first reset signal line 181 on the reference plane at least partially overlap, a distance between the film layer where the first power line 151 is located and a film layer where the first reset signal line 181 is located is large, so as to reduce the parasitic capacitance.

For example, in a case where the first power line 151 and the first reset signal line 181 are located in different film layers, compared to the embodiments where the orthogonal projections of the first power line 151 and the first reset signal line 181 on the reference plane do not overlap, in the embodiments where the orthogonal projections of the first power line 151 and the first reset signal line 181 on the reference plane at least partially overlap, an insulating film layer, such as a planarization layer, may be added.

In this case, the first start signal line 161, the first clock signal line 171, the second clock signal line 172, and the second power line 152 may be disposed in a same layer and made of a same material. The first power line 151 and the first reset signal line 181 are located in different layers, and one of the first power line 151 and the first reset signal line 181 may be disposed in a same layer and made of a same material as the first start signal line 161, the first clock signal line 171, the second clock signal line 172, and the second power line 152.

Referring to FIGS. 4 and 15, the display substrate 110 provided by some embodiments of the present disclosure further includes a plurality of third power lines 153 disposed in the peripheral region B.

As shown in FIG. 15, the third power lines 153 extend substantially along the first direction X, and are configured to transmit a fifth signal or a sixth signal. Furthermore, at least three third power lines 153 overlap the scanning driving circuit 121 and divide the scanning shift register GRS into a first scanning sub-circuit 211, a second scanning sub-circuit 212, a third scanning sub-circuit 213 and a fourth scanning sub-circuit 214. The first scanning sub-circuit 211, the second scanning sub-circuit 212, the third scanning sub-circuit 213 and the fourth scanning sub-circuit 214 are proximate to the display region A (see FIG. 4) in sequence.

It will be noted that the fifth signal and the sixth signal are both constant low-level signals or constant high-level signals. Some embodiments of the present disclosure will be illustrated below by taking an example in which the fifth signal and the sixth signal are constant low-level signals, but the embodiments of the present disclosure are not limited thereto.

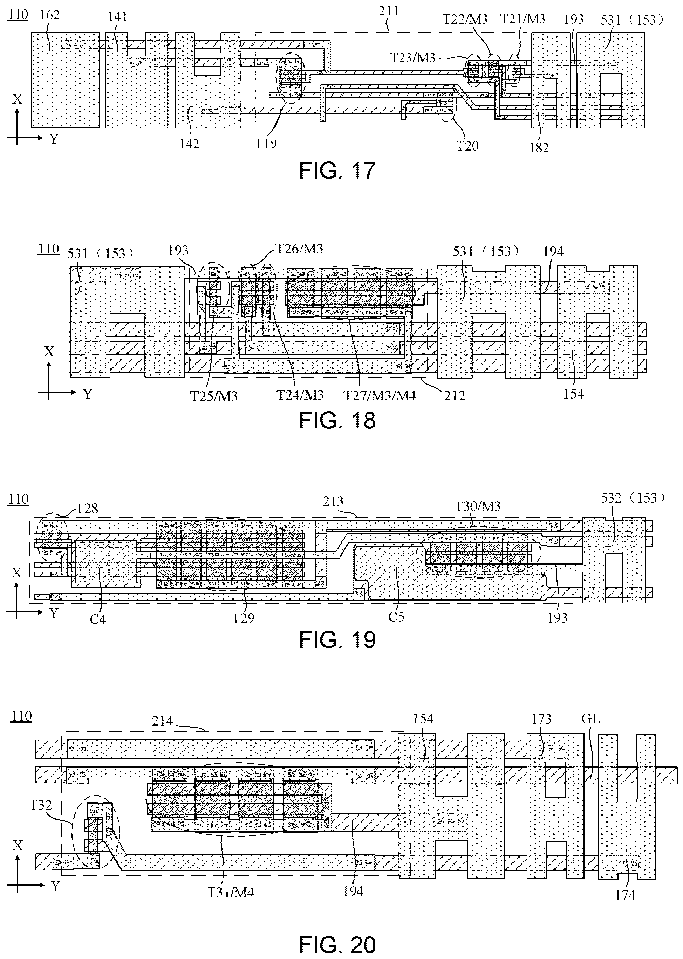

On this basis, referring to FIGS. 17 to 20, the first scanning sub-circuit 211, the second scanning sub-circuit 212 and the third scanning sub-circuit 213 each include a third type transistor M3 connected to a third power line 153. The third type transistors M3 in the first scanning sub-circuit 211, the second scanning sub-circuit 212 and the third scanning sub-circuit 213 are respectively connected to nearest third power lines 153.

Some embodiments of the present disclosure will be illustrated below by taking an example in which the display substrate 110 includes three third power lines 153, but the embodiments of the present disclosure are not limited thereto.

In some embodiments, as shown in FIG. 7, each scanning shift register GRS includes a second signal input terminal STU2, a third signal input terminal STD, a third power signal terminal VGL30, a fourth power signal terminal EN10, a first voltage terminal CN, a second voltage terminal CNB, a third clock signal terminal CLK3, a fourth clock signal terminal CLK4, a second reset signal terminal RST2, a second cascade output terminal CR2 and a scanning signal output terminal OUT2.

On this basis, as shown in FIGS. 7 and 15, the above-mentioned display substrate 110 includes a second start signal line 162, a third start signal line 163, a first voltage signal line 141, a second voltage signal line 142, the third power lines 153, fourth power lines 154, a third clock signal line 173, a fourth clock signal line 174 and a second reset signal line 182.

It will be noted that the first voltage signal line 141 may be of a constant high-level signal, and the second voltage signal line 142 may be of a constant low-voltage signal. The fourth power line 154 may input a high-level signal in a case where the display substrate 110 is abnormally powered off, which is not limited in the present disclosure.

Moreover, the second start signal line 162, the third start signal line 163, the first voltage signal line 141, the second voltage signal line 142, the third power lines 153, the fourth power lines 154, the third clock signal line 173, the fourth clock signal line 174 and the second reset signal line 182 extend substantially along the first direction X and are connected to the scanning shift register GRS.

Here, the second start signal line 162, the third start signal line 163, the first voltage signal line 141, the second voltage signal line 142, the third power lines 153, the fourth power lines 154, the third clock signal line 173, the fourth clock signal line 174 and the second reset signal line 182 are provided with second hollow regions therein. Connecting lines (e.g., first connecting lines 191 and second connecting lines 192 mentioned below) intersecting with the second start signal line 162, the third start signal line 163, the first voltage signal line 141, the second voltage signal line 142, the third power lines 153, the fourth power lines 154, the third clock signal line 173, the fourth clock signal line 174 and the second reset signal line 182 may pass through second hollow regions, so as to reduce an overlapping area and reduce the risk of generating parasitic capacitances and accidental short circuit.

As shown in FIG. 7, a second signal input terminal STU2 of a scanning shift register GRS at a first stage is connected to the second start signal line 162. In scanning shift registers GRS at every two adjacent stages, a second signal input terminal STU2 of a scanning shift register GRS at a next stage is connected to a second cascade output terminal CR2 of a scanning shift register GRS at a previous stage.

As shown in FIG. 7, a third signal input terminal STU3 of a scanning shift register GRS at a last stage is connected to the third start signal line 163. In the scanning shift registers GRS at every two adjacent stages, a third signal input terminal STU3 of the scanning shift register GRS at the previous stage may be connected to a second cascade output terminal CR2 of the scanning shift register GRS at the next stage.

A plurality of third power signal terminals VGL30 may transmit the same low-level signal, such as the fifth signal or the sixth signal. The plurality of third power signal terminals VGL30 may also be configured such that, according to actual conditions, a part of the third power signal terminals VGL30 transmits the fifth signal, and another part of the third power signal terminals VGL30 transmits the sixth signal.

That is, the plurality of third power signal terminals VGL30 include a first type third power signal terminal VGL31 and a second type third power signal terminal VGL32. The first type third power signal terminals VGL31 transmit the fifth signal, and the second type third power signal terminals VGL32 transmit the sixth signal.

In this case, the plurality of third power lines 153 may include two first type third power lines 531 and one second type third power line 532. The first type third power line 531 is configured to transmit the fifth signal. The second type third power line 532 is configured to transmit the sixth signal.

It will be noted that, in a case where all the third power lines 153 include two first type third power lines 531 and one second type third power lines 532, one of the two first type third power lines 153 is disposed between the first scanning sub-circuit 211 and the second scanning sub-circuit 212, and another one of the two first type third power lines 153 is disposed between the second scanning sub-circuit 212 and the third scanning sub-circuit 213. The second type third power line 153 is disposed between the third scanning sub-circuit 213 and the fourth scanning sub-circuit 214.

Some embodiments of the present disclosure will be illustrated below by taking an example in which the plurality of third power signal terminals VGL30 include the first type third power signal terminal VGL31 and the second type third power signal terminal VGL32, but the embodiments of the present disclosure are not limited thereto.

In addition, a plurality of fourth power signal terminals EN10 may transmit a same high-level signal, such as a seventh signal or an eighth signal. The plurality of fourth power signal terminals EN10 may also be configured such that, according to actual conditions, a part of the fourth power signal terminals EN10 transmits the seventh signal, and another part of the fourth power signal terminals EN10 transmits the eighth signal.

That is, the plurality of fourth power signal terminals EN10 include a first type fourth power signal terminal EN11 and a second type fourth power signal terminal EN12. The first type fourth power signal terminal EN11 transmits the seventh signal, and the second type fourth power signal terminal EN12 transmits the eighth signal.

It will be noted that the seventh signal is a constant low-level signal or a constant high-level signal, and the eighth signal is a constant high-level signal. Some embodiments of the present disclosure will be illustrated below by taking an example in which the seventh signal is a constant high-level signal, but the embodiments of the present disclosure are not limited thereto.

In this case, the plurality of fourth power lines 154 include two first type fourth power lines 541 and one second type fourth power line 542. The first type fourth power line 541 is configured to transmit the seventh signal. The second type fourth power line 542 is configured to transmit the eighth signal.

Some embodiments of the present disclosure will be illustrated below by taking an example in which the plurality of fourth power signal terminals EN10 include the first type fourth power signal terminal EN11 and the second type fourth power signal terminal EN12, but the embodiments of the present disclosure are not limited thereto.

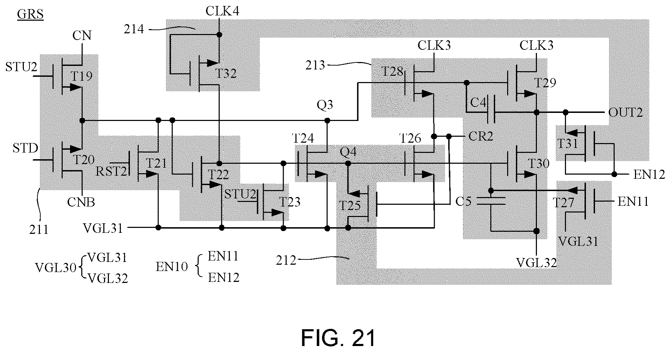

In some examples, referring to FIGS. 17 and 21, the first scanning sub-circuit 211 is coupled to the third power signal terminal VGL30, the second signal input terminal STU2, the third signal input terminal STD, the first voltage terminal CN, the second voltage terminal CNB, the second reset signal terminal RST2, the second cascade output terminal CR2, the third control node Q3 and the fourth control node Q4.

In this case, the first scanning sub-circuit 211 is configured to output a first voltage signal or a second voltage signal to the third control node Q3 and output the fifth signal or the sixth signal to the fourth control node Q4 under control of voltages of the second signal input terminal STU2 and the third signal input terminal STU3, and output the fifth signal or the sixth signal to the third control node Q3 under control of a signal from the second reset signal terminal RST2.

For example, as shown in FIG. 21, the first scanning sub-circuit 211 is connected to the first type third power signal terminal VGL31.

For example, as shown in FIG. 21, the first scanning sub-circuit 211 includes a nineteenth transistor T19, a twentieth transistor T20, a twenty-first transistor T21, a twenty-second transistor T22, and a twenty-third transistor T23.

As shown in FIG. 21, a first electrode of the nineteenth transistor T19 is connected to the first voltage terminal CN, a second electrode of the nineteenth transistor T19 is connected to the third control node Q3, and a control electrode of the nineteenth transistor T19 is connected to the second signal input terminal STU2.

As shown in FIG. 21, a first electrode of the twentieth transistor T20 is connected to the second voltage terminal CNB, a second electrode of the twentieth transistor T20 is connected to the third control node Q3, and a control electrode of the twentieth transistor T20 is connected to the third signal input terminal STD.

As shown in FIG. 21, a first electrode of the twenty-first transistor T21 is connected to the first type third power signal terminal VGL31, a second electrode of the twenty-first transistor T21 is connected to the third control node Q3, and a control electrode of the twenty-first transistor T21 is connected to the second reset signal terminal RST2.

As shown in FIG. 21, a first electrode of the twenty-second transistor T22 is connected to the first type third power signal terminal VGL31, a second electrode of the twenty-second transistor T22 is connected to the fourth control node Q4, and a control electrode of the twenty-second transistor T22 is connected to the third control node Q3.

As shown in FIG. 21, a first electrode of the twenty-third transistor T23 is connected to the first type third power signal terminal VGL31, a second electrode of the twenty-third transistor T23 is connected to the fourth control node Q4, and a control electrode of the twenty-third transistor T23 is connected to the second signal input terminal STU2.

In some examples, referring to FIGS. 18 and 21, the second scanning sub-circuit 212 is coupled to the third power signal terminal VGL30, the fourth power signal terminal EN10, the third control node Q3, the fourth control node Q4, and the second cascade output terminal CR2.

In this case, the second scanning sub-circuit 212 is configured to output the fifth signal or the sixth signal to the second cascade output terminal CR2 under control of a voltage of the fourth control node Q4, and output the fifth signal or the sixth signal to the fourth control node Q4 under control of a signal from the second cascade output terminal CR2 or the fourth power signal terminal EN10.

For example, as shown in FIG. 21, the second scanning sub-circuit 212 is connected to the first type third power signal terminal VGL31 and the first type fourth power signal terminal EN11.

For example, as shown in FIG. 21, the second scanning sub-circuit 212 includes a twenty-fourth transistor T24, a twenty-fifth transistor T25, a twenty-sixth transistor T26, and a twenty-seventh transistor T27.

As shown in FIG. 21, a first electrode of the twenty-fourth transistor T24 is connected to the first type third power signal terminal VGL31, a second electrode of the twenty-fourth transistor T24 is connected to the third control node Q3, and a control electrode of the twenty-fourth transistor T24 is connected to the fourth control node Q4.

As shown in FIG. 21, a first electrode of the twenty-fifth transistor T25 is connected to the first type third power signal terminal VGL31, a second electrode of the twenty-fifth transistor T25 is connected to the fourth control node Q4, and a control electrode of the twenty-fifth transistor T25 is connected to the second cascade output terminal CR2.

As shown in FIG. 21, a first electrode of the twenty-sixth transistor T26 is connected to the first type third power signal terminal VGL31, a second electrode of the twenty-sixth transistor T26 is connected to the second cascade output terminal CR2, and a control electrode of the twenty-sixth transistor T26 is connected to the fourth control node Q4.

As shown in FIG. 21, a first electrode of the twenty-seventh transistor T27 is connected to the first type third power signal terminal VGL31, a second electrode of the twenty-seventh transistor T27 is connected to the fourth control node Q4, and a control electrode of the twenty-seventh transistor T27 is connected to the first type fourth power signal terminal EN11.

In some examples, referring to FIGS. 19 and 21, the third scanning sub-circuit 213 is coupled to the third power signal terminal VGL30, the third clock signal terminal CLK3, the third control node Q3, the fourth control node Q4, the second cascade output terminal CR2, and the scanning signal output terminal OUT2.

In this case, the third scanning sub-circuit 213 is configured to output a third clock signal to the second cascade output terminal CR2 under control of voltages of the third control node Q3 and the fourth control node Q4, and output any one of the third clock signal, the fifth signal and the sixth signal to the scanning signal output terminal OUT2.

For example, as shown in FIG. 21, the third scanning sub-circuit 213 is connected to the second type third power signal terminal VGL32. In this way, the second type third power line 532 may be set separately to avoid interference from other circuits, so that the sixth signal output by the scanning signal output terminal OUT2 is stable.

For example, as shown in FIG. 21, the third scanning sub-circuit 213 includes a twenty-eighth transistor T28, a twenty-ninth transistor T29, a thirtieth transistor T30, a fourth capacitor C4, and a fifth capacitor C5.

As shown in FIG. 21, a first electrode of the twenty-eighth transistor T28 is connected to the third clock signal terminal CLK3, a second electrode of the twenty-eighth transistor T28 is connected to the second cascade output terminal CR2, and a control electrode of the twenty-eighth transistor T28 is connected to the third control node Q3.

As shown in FIG. 21, a first electrode of the twenty-ninth transistor T29 is connected to the third clock signal terminal CLK3, a second electrode of the twenty-ninth transistor T29 is connected to the scanning signal output terminal OUT2, and a control electrode of the twenty-ninth transistor T29 is connected to the third control node Q3.

As shown in FIG. 21, a first electrode of the thirtieth transistor T30 is connected to the second type third power signal terminal VGL32, a second electrode of the thirtieth transistor T30 is connected to the scanning signal output terminal OUT2, and a control electrode of the thirtieth transistor T30 is connected to the fourth control node Q4.

As shown in FIG. 21, a first electrode plate of the fourth capacitor C4 is connected to the third control node Q3, and a second electrode plate of the fourth capacitor C4 is connected to the scanning signal output terminal OUT2.

As shown in FIG. 21, a first electrode plate of the fifth capacitor C5 is connected to the second type third power signal terminal VGL32, and a second electrode plate of the fifth capacitor C5 is connected to the fourth control node Q4.

In some examples, referring to FIGS. 20 and 21, the fourth scanning sub-circuit 214 is coupled to the fourth clock signal terminal CLK4, the fourth power signal terminal EN10, the fourth control node Q4, and the scanning signal output terminal OUT2.

In this case, the fourth scanning sub-circuit 214 is configured to output the seventh signal or the eighth signal to the scanning signal output terminal OUT2 under control of a signal from the fourth power signal terminal EN10, and output a fourth clock signal to the third control node Q3 under control of a signal from the fourth clock signal terminal CLK4.

For example, as shown in FIG. 21, the fourth scanning sub-circuit 214 is connected to the second type fourth power signal terminal EN12. In this way, the second type fourth power line 542 may be set separately to avoid interference from other circuits, so that the eighth signal output by the scanning signal output terminal OUT2 is stable.

For example, as shown in FIG. 21, the fourth scanning sub-circuit 214 includes a thirty-first transistor T31 and a thirty-second transistor T32.

As shown in FIG. 21, a first electrode of the thirty-first transistor T31 is connected to the second type fourth power signal terminal EN12, a second electrode of the thirty-first transistor T31 is connected to the scanning signal output terminal OUT2, and a control electrode of the thirty-first transistor T31 is connected to the second type fourth power signal terminal EN12.

As shown in FIG. 21, a first electrode of the thirty-second transistor T32 is connected to the fourth clock signal terminal CLK4, a second electrode of the thirty-second transistor T32 is connected to the fourth control node Q4, and a control electrode of the thirty-second transistor T32 is connected to the fourth clock signal terminal CLK4.

Based on the above-mentioned first scanning sub-circuit 211, as shown in FIGS. 17 and 21, the third type transistors M3 in the first scanning sub-circuit 211 includes the twenty-first transistor T21, the twenty-second transistor T22, and the twenty-third transistor T23.

As shown in FIGS. 15 and 17, the twenty-first transistor T21, the twenty-second transistor T22, and the twenty-third transistor T23 are directly connected to a third power line 153 located between the first scanning sub-circuit 211 and the second scanning sub-circuit 212, so as to avoid bypassing the wires in the second direction Y, thereby reducing the wiring space of each scanning shift register GRS in the first direction X.

For example, as shown in FIG. 17, the display substrate 110 further includes a plurality of third connecting lines 193, and the third connecting lines 193 extend substantially along the second direction Y. An end of the third connecting line 193 is connected to the third type transistor M3, and another end of the third connecting line 193 is connected to a nearest third power line 153.

For example, as shown in FIG. 17, the twenty-first transistor T21, the twenty-second transistor T22, and the twenty-third transistor T23 may be connected to the third power line 153 (the third power line 153 on the right side in FIG. 17) located between the first scanning sub-circuit 211 and the second scanning sub-circuit 212 through a same third connecting line 193. That is, the third type transistors M3 in the first scanning sub-circuit 211 are connected to a corresponding third power line 153, and there is no need to bypass the wires in the second direction Y, thereby reducing the wiring space of each scanning shift register GRS in the first direction X.

Based on the above second scanning sub-circuit 212, as shown in FIGS. 18 and 21, the third type transistors M3 in the second scanning sub-circuit 212 include the twenty-fourth transistor T24, the twenty-fifth transistor T25, the twenty-sixth transistor T26 and the twenty-seventh transistor T27.

As shown in FIGS. 15 and 18, the twenty-fourth transistor T24, the twenty-fifth transistor T25, the twenty-sixth transistor T26 and the twenty-seventh transistor T27 are connected to at least one of the two third power lines 153 that are located on both sides of the second scanning sub-circuit 212 and adjacent to the second scanning sub-circuit 212, so as to avoid bypassing the wires in the second direction Y, thereby further reducing the wiring space of each scanning shift register GRS in the first direction X.

For example, as shown in FIG. 18, the twenty-fourth transistor T24, the twenty-fifth transistor T25, the twenty-sixth transistor T26 and the twenty-seventh transistor T27 may be connected to the two third power lines 153 that are located on both sides of the second scanning sub-circuit 212 and adjacent to the second scanning sub-circuit 212 through a same third connecting line 193. That is, the third type transistors M3 in the second scanning sub-circuit 212 are connected to the corresponding third power line 153, and there is no need to bypass the wires in the second direction Y, thereby further reducing the wiring space of each scanning shift register GRS in the first direction X.

Based on the third scanning sub-circuit 213, as shown in FIGS. 19 and 21, the third type transistor(s) M3 in the third scanning sub-circuit 213 include the thirtieth transistor T30.

As shown in FIGS. 15 and 19, the thirtieth transistor T30 is connected to a third power line 153 between the second scanning sub-circuit 212 and the third scanning sub-circuit 213, so as to avoid bypassing the wires in the second direction Y, thereby further reducing the wiring space of each scanning shift register GRS in the first direction X.

For example, as shown in FIG. 19, the thirtieth transistor T30 may be connected to the third power line 153 located between the second scanning sub-circuit 212 and the third scanning sub-circuit 213 through the third connecting line 193, and there is no need to bypass the wires in the second direction Y, thereby further reducing the wiring space of each scanning shift register GRS in the first direction X.

In some embodiments, referring to FIGS. 15, 18 and 20, the second scanning sub-circuit 212 and the fourth scanning sub-circuit 214 each include a fourth type transistor M4 connected to a nearest fourth power line 154.

On this basis, as shown in FIG. 15, the display substrate 110 may include a plurality of fourth power lines 154, and the fourth power lines 154 are configured to transmit the seventh signal or the eighth signal.

As shown in FIG. 15, at least one of the plurality of fourth power lines 154 is disposed between the second scanning sub-circuit 212 and the third scanning sub-circuit 213, and another at least one of the plurality of fourth power lines 154 is disposed between the fourth scanning sub-circuit 214 and the display region A (see FIG. 4).

Some embodiments of the present disclosure will be illustrated below by taking an example in which the display substrate 110 includes two fourth power lines 154, and the two fourth power lines 154 are respectively a first type fourth power line 541 and a second type fourth power line 542, but the embodiments of the present disclosure are not limited thereto.

It will be noted that, when the two fourth power lines 154 include a first type fourth power line 541 and a second type fourth power line 542, the first type fourth power line 541 is located between the second scanning sub-circuit 212 and the third scanning sub-circuit 213, and the second type fourth power line 542 is located between the fourth scanning sub-circuit 214 and the display region A (see FIG. 4).

In this case, the fourth type transistors M4 in the second scanning sub-circuit 212 and the fourth scanning sub-circuit 214 may be connected to nearest fourth power lines 154, respectively.

Based on the structures of the second scanning sub-circuit 212 and the fourth scanning sub-circuit 214, as shown in FIGS. 18, 20 and 21, the fourth type transistor M4 in the second scanning sub-circuit 212 includes the twenty-seventh transistor T27. The fourth type transistor M4 in the fourth scanning sub-circuit 214 includes the thirty-first transistor T31.

That is, as shown in FIGS. 15 and 18, the twenty-seventh transistor T27 is connected to the fourth power line 154 located between the second scanning sub-circuit 212 and the third scanning sub-circuit 213. As shown in FIGS. 15 and 20, the thirty-first transistor T31 is connected to the fourth power line 154 located between the fourth scanning sub-circuit 214 and the display region A (see FIG. 4).

In this case, the fourth type transistors M4 in the second scanning sub-circuit 212 and the fourth scanning sub-circuit 214 may be directly connected to the nearest fourth power lines 154, so as to avoid bypassing the wires in the second direction Y, thereby further reducing the wiring space of each scanning shift register GRS in the first direction X.

For example, as shown in FIGS. 15 and 18, the display substrate 110 (see FIG. 4) further includes a plurality of fourth connecting lines 194, and the fourth connecting lines 194 extend substantially along the second direction Y. An end of the fourth connecting line 194 is connected to the fourth type transistor M2, and another end of the fourth connecting lines 194 is connected to a nearest fourth power line 154.

As shown in FIGS. 15 and 18, the twenty-seventh transistor T27 and the thirty-first transistor T31 may be connected to the corresponding fourth power lines 154 through fourth connecting lines 194, respectively. That is, the fourth type transistors M4 in the second scanning sub-circuit 212 and the fourth scanning sub-circuit 214 are connected to the corresponding fourth power lines 154, and there is no need to bypass the wires in the second direction Y, thereby further reducing the wiring space of each scanning shift register GRS in the first direction X.

In some embodiments, referring to FIGS. 15, 17, 18 and 19, a width of the third power line 153 connected to the third scanning sub-circuit 213 is less than a width of the third power line 153 connected to the first scanning sub-circuit 211 and/or the second scanning sub-circuit 212. That is, a width of the second type third power line 532 is less than a width of the first type third power line 531.

In this case, since the width of the second type third power line 532 is less than the width of the first type third power line 531, a resistance of the second type third power line 532 is large, and the voltage drop is also large. In this case, in a case where the scanning signal output terminal OUT2 outputs a second high-level, the fourth control node Q4 is at a low-level, and Vgs of the thirtieth transistor T30 is less than 0, which may ensure that the thirtieth transistor T30 is turned off and reduce the risk of leakage.

In some embodiments, referring to FIGS. 4 and 15, the second start signal line 162 is located on a side of the scanning driving circuit 121 away from the display region A. Along the first direction X, the third start signal line 163 may be located on a side of the scanning driving circuit 121 (e.g., a side for bonding the circuit board 400), so as to facilitate the connection with a driving chip. The first voltage signal line 141 is located on the side of the scanning driving circuit 121 away from the display region A. The second voltage signal line 142 is located on the side of the scanning driving circuit 121 away from the display region A. The third clock signal line CLK3 is located between the scanning driving circuit 121 and the display region A. The fourth clock signal line CLK4 is located between the scanning driving circuit 121 and the display region A. The second reset signal line 182 is located between the first scanning sub-circuit 211 and the second scanning sub-circuit 212.

In this case, all of the transistors in the scanning shift register GRS may be connected to the corresponding first voltage signal line 141, second voltage signal line 142, third clock signal line CLK3 and fourth clock signal line CLK4 on both sides of the scanning shift register GRS. And, the transistors in the first scanning sub-circuit 211 may be connected to the first voltage signal line 141, second voltage signal line 142 and second reset signal line 182 on both sides of the first scanning sub-circuit 211. In addition, the third start signal line 163 may be directly connected to the driving chip. In this way, the winding in the second direction Y may be reduced, thereby reducing the wiring space of each scanning shift register GRS in the first direction X.

Here, referring to FIGS. 17 to 20, the nineteenth transistor T19 may be connected to the second start signal line 162 and the first voltage signal line 141, the twentieth transistor T20 may be connected to the second voltage signal line 142, and the twenty-first transistor T21 may be connected to the second reset signal line 182. The twenty-eighth transistor T28 and the twenty-ninth transistor T29 may be connected to the third clock signal line CLK3. The thirty-second transistor T32 may be connected to the fourth clock signal line CLK4.

Here, referring to FIGS. 15 and 16, the positional relationships between the third power lines 153, the fourth power lines 154, the second start signal line 162, the first voltage signal line 141, the second voltage signal line 142, the third clock signal line CLK3, the fourth clock signal line CLK4 and the second reset signal line 182 are not unique, and these lines may be staggered or partially overlapped.

For example, referring to FIGS. 4 and 15, the second start signal line 162, the first voltage signal line 141, and the second voltage signal line 142 are staggered and arranged in sequence at the side of the scanning driving circuit 121 away from the display region A, along the second direction Y, and along the direction from the peripheral region B to the display region A.

The fourth power line 154, the third clock signal line CLK3 and the fourth clock signal line CLK4 are staggered and arranged in sequence between the scanning driving circuit 121 and the display region A, along the second direction Y and along the direction from the peripheral region B to the display region A.

Between the first scanning sub-circuit 211 and the second scanning sub-circuit 212, the third power line 153 is located between the second reset signal line 182 and the second scanning sub-circuit 212.

On this basis, in some examples, as shown in FIG. 15, in the third power line 153 and the fourth power line 154 located between the second scanning sub-circuit 212 and the third scanning sub-circuit 213, the third power line 153 is located on a side of the fourth power line 154 away from or proximate to the display region A. FIG. 15 illustrates an example in which the third power line 153 is located on the side of the fourth power line 154 away from the display region A.

In this case, the second start signal line 162, the third start signal line 163, the third clock signal 173, the fourth clock signal 174, the first voltage signal line 141, the second voltage signal line 142, the third power line 153, the fourth power line 154 and the second reset signal line 182 may be disposed in a same layer and made of a same material.

In some other examples, as shown in FIGS. 4 and 16, orthogonal projections of the third power line 153 and the fourth power line 154 located between the second scanning sub-circuit 212 and the third scanning sub-circuit 213 on the reference plane at least partially overlap, so as to reduce the distance between the third power line 153 and the corresponding connected transistors as well as the distance between the fourth power line 154 and the corresponding connected transistors, reduce the voltage drop, and reduce the wiring space of each signal line in the second direction Y, thereby facilitating the narrow bezel design of the display panel 100.

It can be understood that in a case where the third power line 153 and the fourth power line 154 are located in different film layers, compared to the embodiments where the orthogonal projections of the third power line 153 and the fourth power line 154 on the reference plane do not overlap, in the embodiments where the orthogonal projections of the third power line 153 and the fourth power line 154 on the reference plane at least partially overlap, a distance between a film layer where the third power line 153 is located and a film layer where the fourth power line 154 is located is large, so as to reduce the parasitic capacitance.

For example, in a case where the third power line 153 and the fourth power line 154 are located in different film layers, compared to the embodiments where the orthogonal projections of the third power line 153 and the fourth power line 154 on the reference plane do not overlap, in the embodiments where the orthogonal projections of the third power line 153 and the fourth power line 154 on the reference plane at least partially overlap, an insulating film layer, such as a planarization layer, may be added.

In this case, the second start signal line 162, the third start signal line 163, the third clock signal 173, the fourth clock signal 174, the first voltage signal line 141, the second voltage signal line 142 and the second reset signal line 182 may be disposed in a same layer and made of a same material. The third power line 153 and the fourth power line 154 are located in different layers, and one of the third power line 153 and the fourth power line 154 may be disposed in the same layer and made of the same material as the second start signal line 162, the third start signal line 163, the third clock signal 173, the fourth clock signal 174, the first voltage signal line 141, the second voltage signal line 142 and the second reset signal line 182.

FIG. 5 is a sectional view taken along the section line B-B' in FIG. 4; and FIG. 6 is another sectional view taken along the section line B-B' in FIG. 4. The film layers where the signal lines are located in the embodiments of the present disclosure will be exemplarily described below with reference to FIGS. 5 and 6.

In some embodiments, as shown in FIG. 5, the display substrate 110 includes a substrate 11, a semiconductor layer ACT, a gate insulating layer GI, a gate conductive layer GT, an interlayer insulating layer ILD, a first source-drain conductive layer SD1, and a first planarization layer PLN1 that are stacked in sequence.

As shown in FIG. 5, the semiconductor layer ACT includes the semiconductor channel 31 of the thin film transistor 30. The gate conductive layer GT includes the gate 34 of the thin film transistor 30 and the first electrode plate of each capacitor C. The first source-drain conductive layer SD1 includes the source 32 and the drain 33 of the thin film transistor 30, and the second electrode plate of each capacitor C. Furthermore, the above-mentioned signal lines are staggered and are all located in the first source-drain conductive layer SD1.

In some other embodiments, as shown in FIG. 6, the display substrate 110 includes a substrate 11, a semiconductor layer ACT, a gate insulating layer GI, a gate conductive layer GT, an interlayer insulating layer ILD, a first source-drain conductive layer SD1, a first planarization layer PLN1, a second source-drain conductive layer SD2, and a second planarization layer PLN2 that are stacked in sequence.

As shown in FIG. 6, the semiconductor layer ACT includes the semiconductor channel 31 of the thin film transistor 30. The gate conductive layer GT includes the gate 34 of the thin film transistor 30 and the first electrode plate of each capacitor C. The first source-drain conductive layer SD1 includes the source 32 and the drain 33 of the thin film transistor 30, and the second electrode plate of each capacitor C. A part of the above signal lines may be overlapped. One of two overlapping signal lines is located in the first source-drain conductive layer SD1, and another one of the two overlapping signal lines is located in the second source-drain conductive layer SD2. FIG. 15 illustrates an example in which the first power line 151 overlaps with the second power line 152.

Some embodiments of the present disclosure further provide a method for manufacturing a display substrate. The method is used for manufacturing the display substrate 110 as described in any one of the above embodiments. Referring to FIG. 5, the method for manufacturing the display substrate 110 includes the following.

The semiconductor layer ACT, the gate insulating layer GI, the gate conductive layer GT, the interlayer insulating layer ILD, the first source-drain conductive layer SD1 and the first planarization layer PLN1 are formed on the substrate 11 in sequence.

With reference to FIGS. 5, 8 and 15, the first source-drain conductive layer SD1 includes at least one of the first power line 151, the second power line 152, the third power line 153, the fourth power line 154, the first start signal line 161, the second start signal line 162, the third start signal line 163, the first voltage signal line 141, the second voltage signal line 142, the first clock signal 171, the second clock signal 172, the third clock signal line 173, the first reset signal line 181 and the second reset signal line 182.

In some embodiments, as shown in FIGS. 8 and 15, orthogonal projections of the first power line 151, the second power line 152, the third power line 153, the fourth power line 154, the first start signal line 161, the second start signal line 162, the third start signal line 163, the first voltage signal line 141, the second voltage signal line 142, the first clock signal line 171, the second clock signal line 172, the third clock signal line 173, the first reset signal line 181 and the second reset signal line 182 on the reference plane are staggered.

On this basis, as shown in FIGS. 5, 8 and 15, the first source-drain conductive layer SD1 may, for example, include the first power line 151, the second power line 152, the third power line 153, the fourth power line 154, the first start signal line 161, the second start signal line 162, the third start signal line 163, the first voltage signal line 141, the second voltage signal line 142, the first clock signal line 171, the second clock signal line 172, the third clock signal line 173, the first reset signal line 181 and the second reset signal line 182.

In some other embodiments, as shown in FIGS. 9 and 16, the orthogonal projections of the first power line 151 and the second power line 152 that are located on the side of the light-emitting control circuit 122 away from the display region A (see FIG. 4) on the reference plane at least partially overlap. And/or, the orthogonal projections of the third power line 153 and the fourth power line 154 that are located between the second scanning sub-circuit 212 and the third scanning sub-circuit 213 on the reference plane at least partially overlap.

On this basis, referring to FIG. 6, the method for manufacturing the display substrate 110 further includes that the second source-drain conductive layer SD2 is formed on a side of the first planarization layer PLN1 away from the substrate 11, and the second planarization layer PLN2 is formed on a side of the second source-drain conductive layer SD2 away from the substrate 11.

As shown in FIGS. 6, 9 and 15, in a case where the orthogonal projections of the first power line 151 and the second power line 152 that are located on the side of the light-emitting control circuit 122 away from the display region A (see FIG. 4) on the reference plane at least partially overlap, the first source-drain conductive layer SD1 includes the first power line 151, the third power line 153, the fourth power line 154, the first start signal line 161, the second start signal line 162, the third start signal line 163, the first voltage signal line 141, the second voltage signal line 142, the first clock signal line 171, the second clock signal line 172, the third clock signal line 173, the first reset signal line 181 and the second reset signal line 182. The second source-drain conductive layer SD2 includes the second power line 152.

As shown in FIGS. 6, 8 and 16, in a case where the orthogonal projections of the third power line 153 and the fourth power line 154 that are located between the second scanning sub-circuit 212 and the third scanning sub-circuit 213 on the reference plane at least partially overlap, the first source-drain conductive layer SD1 includes the first power line 151, the second power line 152, the third power line 153, the first start signal line 161, the second start signal line 162, the third start signal line 163, the first voltage signal line 141, the second voltage signal line 142, the first clock signal line 171, the second clock signal line 172, the third clock signal line 173, the first reset signal line 181 and the second reset signal line 182. The second source-drain conductive layer SD2 includes the fourth power line 154.

As shown in FIGS. 6, 9 and 16, in a case where the orthogonal projections of the first power line 151 and the second power line 152 that are located on the side of the light-emitting control circuit 122 away from the display region A (see FIG. 4) on the reference plane at least partially overlap, and the orthogonal projections of the third power line 153 and the fourth power line 154 that are located between the second scanning sub-circuit 212 and the third scanning sub-circuit 213 on the reference plane at least partially overlap, the first source-drain conductive layer SD1 includes the first power line 151, the third power line 153, the first start signal line 161, the second start signal line 162, the third start signal line 163, the first voltage signal line 141, the second voltage signal line 142, the first clock signal line 171, the second clock signal line 172, the third clock signal line 173, the first reset signal line 181 and the second reset signal line 182. The second source-drain conductive layer SD2 includes the second power line 152 and the fourth power line 154.

The above are only specific embodiments of the present disclosure, but the scope of protection of the present disclosure is not limited thereto, and any person skilled in the art may conceive of variations or replacements within the technical scope of the present disclosure, which shall fall within the protection scope of the present disclosure. Therefore, the protection scope of the present disclosure should be determined by the protection scope of the claims.

## Claims

1. A display substrate having a display region and a peripheral region located on at least one side of the display region, the display substrate comprising:
a plurality of first power lines disposed in the peripheral region, wherein a first power line extends substantially along a first direction and is configured to transmit a first signal or a second signal; and
a light-emitting control circuit disposed in the peripheral region, wherein the light-emitting control circuit includes a plurality of light-emitting shift registers that are cascaded; at least one first power line is located on a side of the light-emitting control circuit away from the display region, and other at least two first power lines overlap the light-emitting control circuit and divide a light-emitting shift register into a first light-emitting sub-circuit, a second light-emitting sub-circuit and a third light-emitting sub-circuit; the first light-emitting sub-circuit, the second light-emitting sub-circuit and the third light-emitting sub-circuit are proximate to the display region in sequence, wherein
the first light-emitting sub-circuit and the third light-emitting sub-circuit each include a first type transistor connected to a first power line, and first type transistors are connected to nearest first power lines, respectively.

2. The display substrate according to claim 1, further comprising:
a plurality of second power lines, wherein a second power line extends substantially along the first direction and is configured to transmit a third signal or a fourth signal; in the plurality of second power lines, at least one second power line is disposed on the side of the light-emitting control circuit away from the display region, and another at least one second power line is disposed between the light-emitting control circuit and the display region, wherein
the first light-emitting sub-circuit and the third light-emitting sub-circuit each include a second type transistor, and second type transistors in the first light-emitting sub-circuit and the third light-emitting sub-circuit are connected to nearest second power lines, respectively.

3. The display substrate according to claim 2, wherein orthogonal projections of a first power line and a second power line that are located on the side of the light-emitting control circuit away from the display region on a reference plane at least partially overlap; the reference plane is a plane where a surface of a non-display side of the display substrate is located.

4. The display substrate according to claim 2, wherein in a first power line and a second power line that are located on the side of the light-emitting control circuit away from the display region, the first power line is located on a side of the second power line away from or proximate to the display region.

5. The display substrate according to any one of claims 2 to 4, wherein a width of a second power line connected to the third light-emitting sub-circuit is less than a width of a second power line connected to the first light-emitting sub-circuit.

6. The display substrate according to any one of claims 2 to 5, further comprising:
a plurality of second connecting lines extending substantially along a second direction, wherein the second direction intersects the first direction; an end of a second connecting line is connected to a second type transistor, and another end of the second connecting line is connected to a nearest second power line.

7. The display substrate according to any one of claims 2 to 6, wherein the at least two second power lines include:
a first type second power line configured to transmit the third signal, the first type second power line being disposed on the side of the light-emitting control circuit away from the display region; and
a second type second power line configured to transmit the fourth signal, the second type second power line being disposed between the light-emitting control circuit and the display region.

8. The display substrate according to any one of claims 2 to 7, wherein the first light-emitting sub-circuit is coupled to a first power signal terminal, a second power signal terminal, a first signal input terminal, a first reset signal terminal, a first clock signal terminal, a second clock signal terminal, a first cascade output terminal, a first control node, and a second control node; the first light-emitting sub-circuit is configured to: under control of signals from the first signal input terminal, the first clock signal terminal, and the second clock signal terminal, output any one of the first signal, the second signal, the third signal, and the fourth signal to the first control node, the second control node, and the first cascade output terminal; and under control of a signal from the first reset signal terminal, output a first clock signal to the first control node, and output the first signal or the second signal to the second control node;
the second light-emitting sub-circuit is coupled to the first control node and an enable signal output terminal; the second light-emitting sub-circuit is configured to raise a voltage of the first control node in a case where the enable signal output terminal outputs the first signal or the second signal; and
the third light-emitting sub-circuit is coupled to the first power signal terminal, the second power signal terminal, the first control node, the second control node and the enable signal output terminal; the third light-emitting sub-circuit is configured to output any one of the first signal, the second signal, the third signal and the fourth signal to the enable signal output terminal under control of voltages of the first control node and the second control node, and raise a voltage of the second control node in a case where the enable signal output terminal outputs the third signal or the fourth signal.

9. The display substrate according to any one of claims 1 to 8, wherein a width of a first power line connected to the third light-emitting sub-circuit is greater than a width of a first power line connected to the first light-emitting sub-circuit.

10. The display substrate according to any one of claims 1 to 9, further comprising:
a plurality of first connecting lines extending substantially along a second direction; wherein the second direction intersects the first direction; an end of a first connecting line is connected to a first type transistor, and another end of the first connecting line is connected to a nearest first power line.

11. The display substrate according to any one of claims 1 to 10, further comprising:
a first start signal line connected to the light-emitting control circuit, the first start signal line being located on the side of the light-emitting control circuit away from the display region;
a first clock signal line connected to the light-emitting control circuit, the first clock signal line being located on the side of the light-emitting control circuit away from the display region;
a second clock signal line connected to the light-emitting control circuit, the second clock signal line being located on the side of the light-emitting control circuit away from the display region; and
a first reset signal line connected to the light-emitting control circuit, the first reset signal line being located between two first power lines overlapping with the light-emitting control circuit.

12. The display substrate according to any one of claims 1 to 11, further comprising:
a plurality of third power lines disposed in the peripheral region, wherein a third power line extends substantially along the first direction, and is configured to transmit a fifth signal or a sixth signal; and
a scanning driving circuit disposed in the peripheral region, wherein the scanning driving circuit includes a plurality of scanning shift registers that are cascaded; at least three third power lines overlap the scanning driving circuit and divide the scanning shift register into a first scanning sub-circuit, a second scanning sub-circuit, a third scanning sub-circuit and a fourth scanning sub-circuit; the first scanning sub-circuit, the second scanning sub-circuit, the third scanning sub-circuit and the fourth scanning sub-circuit are proximate to the display region in sequence, wherein
the first scanning sub-circuit, the second scanning sub-circuit and the third scanning sub-circuit each include a third type transistor connected to a third power line; third type transistors in the first scanning sub-circuit, the second scanning sub-circuit and the third scanning sub-circuit are connected to nearest third power lines, respectively.

13. The display substrate according to claim 12, further comprising:
a plurality of fourth power lines, wherein a fourth power line extends substantially along the first direction and is configured to transmit a seventh signal or an eighth signal; in the plurality of fourth power lines, at least one fourth power line is disposed between the second scanning sub-circuit and the third scanning sub-circuit, and another at least one fourth power line is disposed between the fourth scanning sub-circuit and the display region; wherein
the second scanning sub-circuit and the fourth scanning sub-circuit each include a fourth type transistor, and fourth type transistors in the second scanning sub-circuit and the fourth scanning sub-circuit are connected to nearest fourth power lines, respectively.

14. The display substrate according to claim 13, wherein orthogonal projections of a third power line and a fourth power line that are located between the second scanning sub-circuit and the third scanning sub-circuit on a reference plane at least partially overlap; the reference plane is a plane where a display surface of the display substrate is located.

15. The display substrate according to claim 13, wherein in a third power line and a fourth power line that are located between the second scanning sub-circuit and the third scanning sub-circuit, the third power line is located on a side of the fourth power line away from or proximate to the display region.

16. The display substrate according to any one of claims 13 to 15, wherein a width of a third power line connected to the third scanning sub-circuit is less than a width of a third power line connected to the first scanning sub-circuit and/or the second scanning sub-circuit.

17. The display substrate according to any one of claims 13 to 16, comprising:
a plurality of fourth connecting lines extending substantially along a second direction; wherein the second direction intersects the first direction; an end of a fourth connecting line is connected to a fourth type transistor, and another end of the fourth connecting line is connected to a nearest fourth power line.

18. The display substrate according to any one of claims 13 to 17, wherein the first scanning sub-circuit is coupled to a third power signal terminal, a second signal input terminal, a third signal input terminal, a first voltage terminal, a second voltage terminal, a second reset signal terminal, a second cascade output terminal, a third control node and a fourth control node;
the first scanning sub-circuit is configured to: output a first voltage signal or a second voltage signal to the third control node under control of voltages of the second signal input terminal and the third signal input terminal; output the fifth signal or the sixth signal to the fourth control node; and output the fifth signal or the sixth signal to the third control node under control of a signal from the second reset signal terminal;
the second scanning sub-circuit is coupled to the third power signal terminal, a fourth power signal terminal, the third control node, the fourth control node and the second cascade output terminal; the second scanning sub-circuit is configured to output the fifth signal or the sixth signal to the second cascade output terminal under control of a voltage of the fourth control node, and output the fifth signal or the sixth signal to the fourth control node under control of a signal from the second cascade output terminal or the fourth power signal terminal;
the third scanning sub-circuit is coupled to the third power signal terminal, a third clock signal terminal, the third control node, the fourth control node, the second cascade output terminal and a scanning signal output terminal; the third scanning sub-circuit is configured to output a third clock signal to the second cascade output terminal under control of voltages of the third control node and the fourth control node, and output any one of the third clock signal, the fifth signal and the sixth signal to the scanning signal output terminal; and
the fourth scanning sub-circuit is coupled to a fourth clock signal terminal, the fourth power signal terminal, the fourth control node and the scanning signal output terminal; the fourth scanning sub-circuit is configured to output the seventh signal or the eighth signal to the scanning signal output terminal under control of the signal from the fourth power signal terminal, and output a fourth clock signal to the fourth control node under control of a signal from the fourth clock signal terminal.

19. The display substrate according to any one of claims 12 to 18, comprising:
a plurality of third connecting lines extend substantially along a second direction; wherein the second direction intersects the first direction; an end of a third connecting line is connected to a third type transistor, and another end of the third connecting line is connected to a nearest third power line.

20. The display substrate according to any one of claims 12 to 19, wherein the plurality of third power lines include:
two first type third power lines configured to transmit the fifth signal, wherein a first type third power line is disposed between the first scanning sub-circuit and the second scanning sub-circuit, and another first type third power line is disposed between the second scanning sub-circuit and the third scanning sub-circuit; and
a second type third power line configured to transmit the sixth signal, wherein the second type third power line is disposed between the third scanning sub-circuit and the fourth scanning sub-circuit.

21. The display substrate according to any one of claims 12 to 20, further comprising:
a second start signal line connected to the scanning driving circuit, the second start signal line being located on a side of the scanning driving circuit away from the display region;
a third start signal line connected to the scanning driving circuit, the third start signal line being located on a side of the scanning driving circuit along the first direction;
a first voltage signal line connected to the scanning driving circuit, the first voltage signal line being located on the side of the scanning driving circuit away from the display region;
a second voltage signal line connected to the scanning driving circuit, the second voltage signal line being located on the side of the scanning driving circuit away from the display region;
a third clock signal line connected to the scanning driving circuit, the third clock signal line being located between the scanning driving circuit and the display region;
a fourth clock signal line connected to the scanning driving circuit, the fourth clock signal line being located between the scanning driving circuit and the display region; and
a second reset signal line connected to the scanning driving circuit, the second reset signal line being located between the first scanning sub-circuit and the second scanning sub-circuit.

22. A display panel, comprising the display substrate according to any one of claims 1 to 21.

23. A display apparatus, comprising the display panel according to claim 22.

24. A method for manufacturing a display substrate, used for manufacturing the display substrate according to any one of claims 1 to 21, wherein the display substrate includes a first power line, a second power line, a third power line, a fourth power line, a first start signal line, a second start signal line, a third start signal line, a first voltage signal line, a second voltage signal line, a first clock signal line, a second clock signal line, a third clock signal line, a first reset signal line and a second reset signal line; and the method for manufacturing the display substrate comprises:
forming a semiconductor layer, a gate insulating layer, a gate conductive layer, an interlayer insulating layer, a first source-drain conductive layer and a first planarization layer on a substrate in sequence, wherein
the first source-drain conductive layer includes at least one of the first power line, the second power line, the third power line, the fourth power line, the first start signal line, the second start signal line, the third start signal line, the first voltage signal line, the second voltage signal line, the first clock signal line, the second clock signal line, the third clock signal line, the first reset signal line and the second reset signal line.

25. The method for manufacturing the display substrate according to claim 24, wherein orthogonal projections of the first power line, the second power line, the third power line, the fourth power line, the first start signal line, the second start signal line, the third start signal line, the first voltage signal line, the second voltage signal line, the first clock signal line, the second clock signal line, the third clock signal line, the first reset signal line and the second reset signal line on a reference plane are staggered; the reference plane is a plane where a surface of a non-display side of the display substrate is located; and
the first source-drain conductive layer includes the first power line, the second power line, the third power line, the fourth power line, the first start signal line, the second start signal line, the third start signal line, the first voltage signal line, the second voltage signal line, the first clock signal line, the second clock signal line, the third clock signal line, the first reset signal line and the second reset signal line.

26. The method for manufacturing the display substrate according to claim 24, wherein orthogonal projections of the first power line and the second power line located on a side of the light-emitting control circuit away from the display region on a reference plane at least partially overlap; and/or orthogonal projections of the third power line and the fourth power line located between the second scanning sub-circuit and the third scanning sub-circuit on the reference plane at least partially overlap; the reference plane is a plane where a surface of a non-display side of the display substrate is located;
the method for manufacturing the display substrate further comprises:
forming a second source-drain conductive layer on a side of the first planarization layer away from the substrate; and
forming a second planarization layer on a side of the second source-drain conductive layer away from the substrate; wherein
in a case where the orthogonal projections of the first power line and the second power line located on the side of the light-emitting control circuit away from the display region on the reference plane at least partially overlap, the first source-drain conductive layer includes the first power line, the third power line, the fourth power line, the first start signal line, the second start signal line, the third start signal line, the first voltage signal line, the second voltage signal line, the first clock signal line, the second clock signal line, the third clock signal line, the first reset signal line and the second reset signal line; the second source-drain conductive layer includes the second power line;
in a case where the orthogonal projections of the third power line and the fourth power line located between the second scanning sub-circuit and the third scanning sub-circuit on the reference plane at least partially overlap, the first source-drain conductive layer includes the first power line, the second power line, the third power line, the first start signal line, the second start signal line, the third start signal line, the first voltage signal line, the second voltage signal line, the first clock signal line, the second clock signal line, the third clock signal line, the first reset signal line and the second reset signal line; the second source-drain conductive layer includes the fourth power line; and
in a case where the orthogonal projections of the first power line and the second power line located on the side of the light-emitting control circuit away from the display region on the reference plane at least partially overlap, and the orthogonal projections of the third power line and the fourth power line located between the second scanning sub-circuit and the third scanning sub-circuit on the reference plane at least partially overlap, the first source-drain conductive layer includes the first power line, the third power line, the first start signal line, the second start signal line, the third start signal line, the first voltage signal line, the second voltage signal line, the first clock signal line, the second clock signal line, the third clock signal line, the first reset signal line and the second reset signal line; the second source-drain conductive layer includes the second power line and the fourth power line.
